# EUROPEAN PATENT APPLICATION

(11) **EP 4 629 807 A1**
(43) Date of publication of application: **08.10.2025**
(21) Application number: 25168262.1
(22) Date of filing: 03.04.2025
(51) Int. Cl.: H10K 59/131, H10K 59/88, H10K 71/00

(54) **DISPLAY APPARATUS AND ELECTRONIC APPARATUS INCLUDING THE DISPLAY APPARATUS**

(30) Priority: 03.04.2024 KR 20240045570
(71) Applicant: Samsung Display Co., Ltd., Yongin-si, Gyeonggi-do 17113 (KR)
(72) Inventor: Lee, Changyeol, 17113 Yongin-si, Gyeonggi-do (KR); Kim, Jaewon, 17113 Yongin-si, Gyeonggi-do (KR); Kim, Hansol, 17113 Yongin-si, Gyeonggi-do (KR); Noh, Jaedu, 17113 Yongin-si, Gyeonggi-do (KR); Lee, Jaesic, 17113 Yongin-si, Gyeonggi-do (KR); Jang, Soyoung, 17113 Yongin-si, Gyeonggi-do (KR); Cho, Youngjin, 17113 Yongin-si, Gyeonggi-do (KR)
(74) Representative: Gulde & Partner

(57) **Abstract**

A display apparatus that may include a substrate that may include an active area and a dummy area, a pixel circuit in the active area and a light-emitting element electrically connected to the pixel circuit and including a pixel electrode, a dummy circuit in the dummy area, a repair line extending in a first direction over the substrate, electrically connected to the dummy circuit, and is connectable to the light-emitting element, a pixel connection electrode overlapping the repair line and electrically connected to the pixel electrode, and a voltage transfer line overlapping the repair line, spaced apart from the pixel connection electrode, and configured to transfer a voltage to the pixel circuit, wherein an area of a portion of the voltage transfer line overlapping the repair line may be greater than an area of a portion of the pixel connection electrode overlapping the repair line.

## Description

### BACKGROUND

### 1. Technical Field

One or more embodiments relate to a display apparatus, and more particularly, to a display apparatus to which a repair process is applicable through a dummy pixel.

### 2. Description of the Related Art

During a process of manufacturing a display apparatus, defects may occur in a pixel circuit of a specific pixel. In such case, a defective pixel may always emit light or may be displayed as black regardless of a scan signal and data signal. In this way, a pixel that always emits light may be perceived by an observer as a bright spot, and a pixel that is displayed in black may be perceived by the observer as a dark spot. As circuits in pixels becomes more complex, it has become difficult to overcome bright or dark spots by repairing the pixel circuits of defective pixels.

### SUMMARY

One or more embodiments include a display apparatus with an improved display quality, wherein a defective pixel is enabled to normally operate through repair of the defective pixel, and a circuit structure of a dummy pixel used after a repair process is changeable to some extent.

One or more embodiments include a display apparatus having a display quality that is improved by reducing a brightness difference depending on a voltage by reducing a coupling effect of a parasitic capacitor formed between a repair line used in a repair process and a pixel electrode.

Technical objectives to be achieved by an embodiment are not limited to the technical objectives mentioned above, and other technical objectives that are not mentioned will be clearly understood by those of ordinary skill in the art from the description of the disclosure.

Additional aspects will be set forth in part in the description which follows and, in part, will be apparent from the description, or may be learned by practice of the presented embodiments of the disclosure.

According to one or more embodiments, a display apparatus may include a substrate including an active area and a dummy area disposed outside the active area, a pixel circuit disposed in the active area and a light-emitting element electrically connected to the pixel circuit and including a pixel electrode, a dummy circuit disposed in the dummy area, a repair line extending in a first direction on the substrate, the repair line may be electrically connected to the dummy circuit and may be connectable to the light-emitting element, a pixel connection electrode disposed to overlap the repair line and electrically connected to the pixel electrode, and a voltage transfer line that transfers a voltage to the pixel circuit, the voltage transfer line may be disposed to overlap the repair line, and may be spaced apart from the pixel connection electrode, wherein an area of a portion of the voltage transfer line overlapping the repair line may be greater than an area of a portion of the pixel connection electrode overlapping the repair line.

A width of the portion of the voltage transfer line overlapping the repair line in the first direction may be greater than a width of the portion of the pixel connection electrode overlapping the repair line in the first direction.

A width of a portion of the repair line overlapping the voltage transfer line in a second direction perpendicular to the first direction may be greater than a width of a portion of the repair line overlapping the pixel connection electrode in the second direction.

A width of the portion of the voltage transfer line overlapping the repair line in the second direction may be greater than a width of the portion of the pixel connection electrode overlapping the repair line in the second direction.

The display apparatus may further include a voltage line that transfers a voltage to the voltage transfer line, wherein the voltage line may be disposed on the voltage transfer line.

The voltage line may transfer a direct current voltage.

The voltage line may transfer a driving voltage.

The display apparatus may further include a first transistor disposed on the substrate and including a first semiconductor layer and a first gate electrode overlapping the first semiconductor layer, and a second transistor including a second semiconductor layer disposed on the first gate electrode, and a second gate electrode overlapping the second semiconductor layer, wherein the repair line and the second gate electrode of the second transistor may be disposed on a same layer.

The first semiconductor layer may include a silicon semiconductor material, and the second semiconductor layer may include an oxide semiconductor material.

The pixel connection electrode and the voltage transfer line may be disposed on a same layer.

The pixel connection electrode and the voltage transfer line may be disposed on different layers from each other.

According to one or more embodiments, a display apparatus may include a substrate including an active area and a dummy area disposed outside the active area, a plurality of pixels disposed in the active area and each including a pixel circuit and a light-emitting element, a dummy circuit disposed in the dummy area, a first semiconductor layer disposed on the substrate, a first gate layer disposed on the first semiconductor layer, a second gate layer disposed on the first gate layer, a second semiconductor layer disposed on the second gate layer, a third gate layer disposed on the second semiconductor layer, the third gate layer may include a repair line, wherein the repair line may be connected to the dummy circuit, the repair line may be connectable to the light-emitting element of a defective pixel of the plurality of pixels, and the repair line may extend in a first direction, and a connection electrode layer disposed on the third gate layer and including a pixel connection electrode and a voltage transfer line, wherein the pixel connection electrode overlaps the repair line, the connection electrode may be electrically connected to a pixel electrode of the light-emitting element, and the voltage transfer line may overlap the repair line, and the voltage line may be spaced apart from the pixel connection electrode, wherein an area of a portion of the voltage transfer line overlapping the repair line may be greater than an area of a portion of the pixel connection electrode overlapping the repair line.

A width of the portion of the voltage transfer line overlapping the repair line in the first direction may be greater than a width of the portion of the pixel connection electrode overlapping the repair line in the first direction.

A width of a portion of the repair line overlapping the voltage transfer line in a second direction perpendicular to the first direction may be greater than a width of a portion of the repair line overlapping the pixel connection electrode in the second direction.

A width of the portion of the voltage transfer line overlapping the repair line in the second direction may be greater than a width of the portion of the pixel connection electrode overlapping the repair line in the second direction.

The display apparatus may further include a voltage line that transfers a voltage to the voltage transfer line, wherein the voltage line may be disposed on the voltage transfer line.

The voltage line may transfer a direct current voltage.

The voltage line may transfer a driving voltage.

The connection electrode layer may further include a scan line extending in the first direction, the connection electrode layer, for example the scan line, may be spaced apart from the voltage transfer line, and the connection electrode layer, for example the scan line may be configured to transfer a scan signal.

According to one or more embodiments, a display apparatus may include a substrate including an active area and a dummy area disposed outside the active area, a first pixel disposed in the active area and including a first pixel circuit and a first light-emitting element, a second pixel disposed in the active area and including a second pixel circuit and a second light-emitting element, a dummy circuit disposed in the dummy area, a repair line extending in a first direction on the substrate, electrically connected to the dummy circuit, and connectable to the first light-emitting element or the second light-emitting element, a first pixel connection electrode disposed on the repair line to overlap the repair line and electrically connected to a first pixel electrode of the first light-emitting element, a second pixel connection electrode disposed on the repair line to overlap the repair line and electrically connected to a second pixel electrode of the second light-emitting element, and a voltage transfer line disposed to overlap the repair line, the voltage transfer line may be spaced apart from the first pixel connection electrode and the second pixel connection electrode, and the voltage transfer line may be electrically connected to each of the first pixel circuit and the second pixel circuit, wherein an area of a portion of the voltage transfer line overlapping the repair line may be greater than an area of a portion of the first pixel connection electrode overlapping the repair line, and a portion of the voltage transfer line overlapping the repair line may be located between the portion of the first pixel connection electrode overlapping the repair line and the portion of the second pixel connection electrode overlapping the repair line.

According to one or more embodiments, an electronic apparatus may include a display apparatus, wherein the display apparatus may include a substrate including an active area and a dummy area disposed outside the active area, a pixel circuit disposed in the active area and a light-emitting element electrically connected to the pixel circuit and including a pixel electrode, a dummy circuit disposed in the dummy area, a repair line extending in a first direction on the substrate, the repair line is electrically connected to the dummy circuit and is connectable to the light-emitting element, a pixel connection electrode disposed to overlap the repair line and electrically connected to the pixel electrode, and a voltage transfer line that transfers a voltage to the pixel circuit, the voltage transfer line is disposed to overlap the repair line, and is spaced apart from the pixel connection electrode, wherein an area of a portion of the voltage transfer line overlapping the repair line may be greater than an area of a portion of the pixel connection electrode overlapping the repair line.

The electronic apparatus may further include a display module, a processor, a power module, and a memory, wherein the display apparatus may include one of the display module, the processor, the power module, or the memory.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic view of a display apparatus according to an embodiment;
FIG. 2 is a schematic view of a display part shown in FIG. 1 according to an embodiment;
FIG. 3 is a view to explain a method of repairing, by a display part shown in FIG. 2, a defective pixel by using a repair line;
FIG. 4 is a schematic view of a display part shown in FIG. 1 according to an embodiment;
FIG. 5 is a schematic diagram of an equivalent circuit of a pixel according to an embodiment;
FIG. 6 is a schematic diagram of an equivalent circuit of a dummy pixel according to an embodiment;
FIG. 7 is a schematic diagram of an equivalent circuit of some pixels according to an embodiment;
FIG. 8 is a schematic configuration view of the positions of transistors and a capacitor in pixels of a display apparatus according to an embodiment;
FIGS. 9 to 19 are schematic configuration views of elements such as transistors, a capacitor, and the like, of a display apparatus shown in FIG. 8, for respective layers;
FIG. 20A is a configuration view of some layers of a display apparatus according to an embodiment;
FIG. 20B is an enlarged view of a region 'A' of FIG. 20A;
FIG. 21A is a configuration view of some layers of a display apparatus according to an embodiment;
FIG. 21B is an enlarged view of a region 'B' of FIG. 21A;
FIG. 22 is a schematic cross-sectional view of a display apparatus according to an embodiment;
FIG. 23 is a schematic cross-sectional view of a display apparatus according to an embodiment;
FIG. 24 is a block diagram of an electronic apparatus according to an embodiment; and
Fig. 25 is a schematic diagrams of electronic apparatuses according to various embodiments.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc., (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the x-direction, the y-direction, and the z-direction are not limited to the directions of three axes of a rectangular coordinate system, and may be interpreted in a broader sense. For example, the x-direction, the y-direction, and the z-direction may be perpendicular to one another, or may be different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc., may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, parts, and/or modules. Those skilled in the art will appreciate that these blocks, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, parts, and/or modules being implemented by microprocessors or other similar hardware, they may be programmed and controlled using software (e.g., microcode) to perform various functions discussed herein and may optionally be driven by firmware and/or software. It is also contemplated that each block, part, and/or module may be implemented by dedicated hardware, or as a combination of dedicated hardware to perform some functions and a processor (e.g., one or more programmed microprocessors and associated circuitry) to perform other functions. Also, each block, part, and/or module of some embodiments may be physically separated into two or more interacting and discrete blocks, parts, and/or modules without departing from the scope of the inventive concepts. Further, the blocks, parts, and/or modules of some embodiments may be physically combined into more complex blocks, parts, and/or modules without departing from the scope of the inventive concepts.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

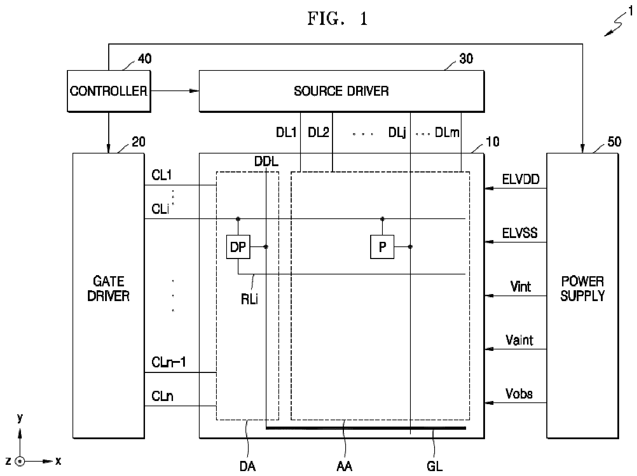

FIG. 1 is a schematic block diagram of an organic light-emitting display apparatus 1 according to an embodiment.

Referring to FIG. 1, the display apparatus 1 may include a display part 10, a gate driver 20, a source driver 30, a controller 40, and a power supply 50. The display part 10, the gate driver 20, the source driver 30, the controller 40, and the power supply 50 may be formed in separate semiconductor chips, respectively, or integrated in a semiconductor chip (e.g., single semiconductor chip). For example, the gate driver 20 and/or the source driver 30 may be formed on the same substrate as the display part 10. The display apparatus 1 may be a part for displaying images of electronic apparatuses, for example, smartphones, tablet personal computers (PCs), notebook PCs, monitors, televisions (TVs), and the like.

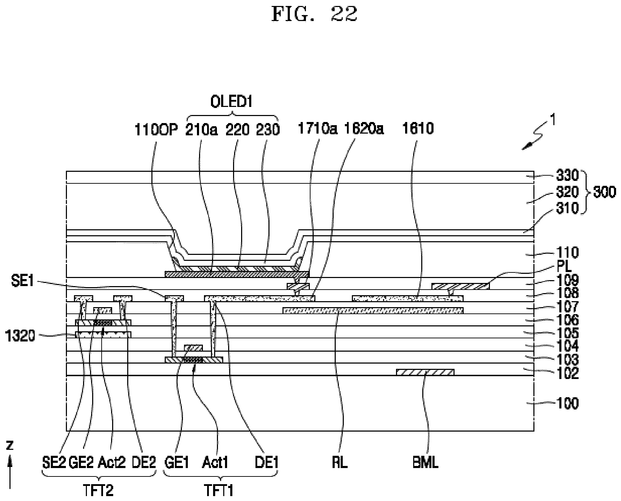

An active area AA (a display area) and a dummy area DA may be defined in the display part 10. The dummy area DA may be disposed in a non-display area to be adjacent to the active area AA. The dummy area DA may be disposed on the left and/or right of the active area AA. As an example, the dummy area DA may be disposed on the upper side and/or lower side of the active area AA. As described with reference to FIG. 22, because the display part 10 includes a substrate 100, it may be understood that the substrate 100 may include the active area AA and the dummy area DA.

Multiple pixels P may be disposed in the active area AA, wherein the pixels P may be connected to multiple control lines CL1, ..., CLi, ..., CLn-1, and CLn extending in a first direction (e.g., an x direction) and multiple data lines DL1, DL2, ..., DLj, ..., and DLm extending in a second direction (e.g., a y direction), where n may be a positive integer, m may be a positive integer, i may be a positive integer less than or equal to n, and j may be a positive integer less than or equal to m. Multiple dummy pixels DP may be disposed in the dummy area DA, wherein each of the dummy pixels DP may be connected to a dummy data line DDL and a corresponding control line CLi (also referred to as an i-th control line CLi) among multiple control lines CL1 to CLn. The dummy pixel DP may be disposed in the second direction in the dummy area DA.

In FIG. 1, for convenience of description, although the control lines CL1 to CLn are shown as a signal line (e.g., single signal line), each of the control lines CL1 to CLn may include multiple signal lines. As an example, the first control line CL1 may include three lines configured to apply a scan signal GW, an initialization control signal GI, and an emission control signal EM.

The display part 10 may include multiple repair lines RL1 to RLn extending in parallel to the control lines CL1 to CLn. The repair lines RL1 to RLn may be connected to the dummy pixels DP and may be connectable to the pixels P.

A unit pixel may include multiple sub-pixels configured to respectively display multiple colors. In the specification, the pixel P denotes a sub-pixel. For example, in the specification, in case that a pixel P is described to be present, it may be interpreted that a sub-pixel may be present.

In the specification, a term "connectable" or "connectably" may mean a state that may be connected using a laser beam or the like in a repair process. For example, in case that a first member and a second member may be connectable, it may mean that the first member and the second member are not actually connected, but may be in a state where they may be connected to each other during a repair process. From a structural point of view, a first member and a second member that may be "connectable" to each other may be disposed to intersect each other in an overlapping region with an insulating layer therebetween. During the repair process, in case that a laser beam is irradiated to the overlapping region, the insulating layer in the overlapping region may be destroyed and the first member and the second member may become electrically connected to each other.

In the specification, a term "separable" or "separably" may mean a state that may be separated (or disconnected) using a laser beam or the like in a repair process. For example, in case that a first member and a second member are connected to be separable, it may mean that the first member and the second member are actually connected, but are in a state where they may be separated from each other during a repair process. From a structural point of view, a first member and a second member that are separably connected to each other may be connectable through a conductive connection member. During a repair process, in case that a laser beam is irradiated onto the conductive connection member, a portion of the conductive connection member to which the laser beam is irradiated may be cut while melting, and the first member and the second member may become electrically insulated from each other. As an example, the conductive connection member may include a silicon layer that may be melted by a laser beam. According to an example, the conductive connection member may be cut while melting due to Joule heat caused by an electric current.

The display part 10 may include a connection line GL that may be connected to the dummy data line DDL and may be connectable to the data lines DL1 to DLm. The connection line GL may extend in the first direction. The connection line GL may be disposed in a dead space outside the active area AA and the dummy area DA. The dead space may denote a region where the pixels P and the dummy pixels DP may not be disposed in the display part 10. Because the connection line GL may be disposed in the dead space, the connection line GL may be formed with a large design margin. As an example, the connection line GL may have a wider width and/or thickness to reduce a resistance. Multiple connection lines GL may be disposed in the display part 10.

The gate driver 20 may be configured to provide multiple control signals to the pixels P and the dummy pixels DP through the control lines CL1 to CLn, and the source driver 30 may be configured to provide data signals to the pixels P through the data lines DL1 to DLm. As shown in FIG. 1, the source driver 30 may not be connected (e.g., directly connected) to the dummy data line DDL. In an example, the source driver 30 may be connected (e.g., directly connected) to the dummy data line DDL and configured to provide (e.g., directly provide) data signals to the dummy pixels DP.

The controller 40 may be configured to control the gate driver 20, the source driver 30, and the power supply 50. The controller 40 may be configured to output control signals for controlling the gate driver 20, the source driver 30, and/or the power supply 50 and image data to the gate driver 20, the source driver 30, and/or the power supply 50 based on a horizontal synchronization signal and a vertical synchronization signal. The power supply 50 may be configured to apply a driving voltage ELVDD, a common voltage ELVSS, a first initialization voltage Vint, a second initialization voltage Vaint, and a bias voltage Vobs to the pixels P and/or the dummy pixels DP.

The pixel P may include a light-emitting element and a pixel circuit separably connected to the light-emitting element. The dummy pixel DP may include a dummy circuit. As an example, in the case where the pixel P shown in FIG. 1 is a defective pixel, a light-emitting element of the defective pixel may be separated from the pixel circuit of the defective pixel and may be connected to a corresponding dummy pixel DP among the dummy pixels DP through a corresponding repair line RLi among repair lines RL1 to RLn. A data line DLj (also referred to as a j-th data line DLj) connected to the defective pixel among the data lines DL1 to DLm may be connected to the dummy data line DDL through the connection line GL. A data signal applied to the defective pixel may be applied to the dummy pixel DP through the data line DLj, the connection line GL connected to the data line DLj, and the dummy data line DDL connected to the connection line GL. The dummy pixel DP may be configured to generate a driving current corresponding to a data signal and supply the driving current to the light-emitting element of the defective pixel through the repair line RLi. The light-emitting element may be configured to emit light of a brightness corresponding to a data signal. Accordingly, the light-emitting element of the defective pixel normally operates due to the dummy pixel DP.

In the specification, a term "corresponding" or "correspondingly" may mean placed in the same column or row, depending on the context. As an example, in case that a first member is connected to a "corresponding" second member among multiple second members, it means that the first member is connected to the second member disposed in the same column or row as the first member.

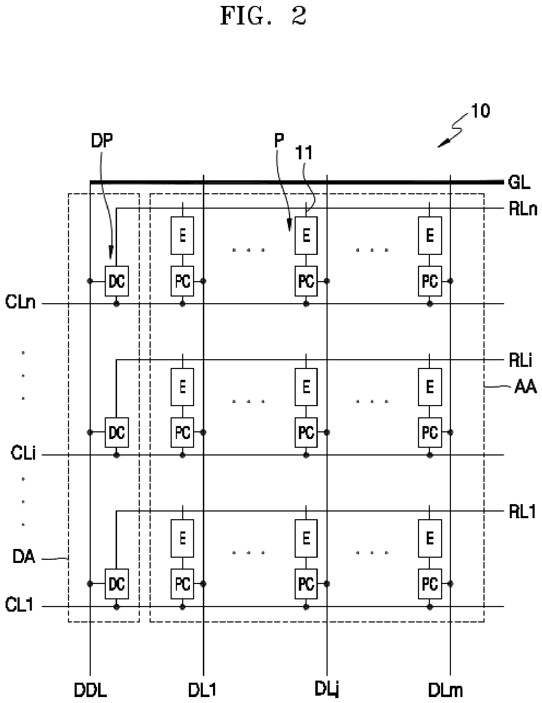

FIG. 2 is a schematic view of the display part 10 shown in FIG. 1 according to an embodiment.

Referring to FIG. 2, the display part 10 may include the active area AA and the dummy area DA around the active area AA, wherein the active area AA may be configured to display images using light emission.

The pixel P disposed in the active area AA may include a pixel circuit PC and a light-emitting element E configured to emit light by receiving the driving current from the pixel circuit PC. The light-emitting element E and the pixel circuit PC may be separably connected to each other. The pixel circuit PC may include at least one thin-film transistors and capacitive elements. In the specification, the capacitive element may denote a capacitor. The pixel P may be configured to emit light of a color (e.g., single color), for example, red, blue, green, or white light. However, the disclosure is not limited thereto and the pixel P may be configured to emit light of a color other than red, blue, green, and white.

The light-emitting element E of the pixel P may be insulated from a repair line in the same row and electrically connected to the repair line during a later repair process. For example, the light-emitting element E of the pixel P may be connectable to the repair line in the same row. As an example, the light-emitting element E may be electrically connected to a first connection member 11, and the first connection member 11 may be formed to partially overlap the repair line with an insulating layer therebetween. The first connection member 11 may include at least one conductive layers including a conductive material. During the repair process, in case that a laser beam is irradiated to an overlapping portion of the first connection member 11 and the repair line, while the insulating layer may be destroyed, the first connection member 11 and the repair line are short-circuited and electrically connected to each other. Accordingly, the light-emitting element E may be electrically connected to the repair line.

An embodiment of FIG. 2 shows an example in which the dummy area DA may be disposed on the left of the active area AA, and a dummy pixel DP(e.g., single dummy pixel DP) may be disposed in each row. The dummy data line DDL connected to the dummy pixels DP may be disposed in the dummy area DA. The dummy data line DDL may be disposed in parallel to the data lines DL1 to DLm. The repair lines RL1 to RLn and the control lines CL1 to CLn may also extend to the dummy area DA.

The dummy pixel DP may include a dummy circuit DC and may not include a light-emitting element. The dummy circuit DC may be the same as the pixel circuit PC. According to an example, the dummy circuit DC may be different from the pixel circuit PC. As an example, in the dummy circuit DC, a transistor and/or a capacitive element of the pixel circuit PC may be omitted and/or added, or the size and characteristic of the transistor and the capacitive element may be different.

The connection line GL may be disposed outside the active area AA and the dummy area DA. The connection line GL may be insulated from the data lines DL1 to DLm. During the repair process, the connection line GL may be electrically connected to one of the data lines DL1 to DLm. As an example, the data lines DL1 to DLm may be disposed to partially overlap the connection line GL with an insulating layer therebetween. During the repair process, in case that a laser beam is irradiated to an overlapping region of the data line connected to a defective pixel and the connection line GL, while the insulating layer is destroyed, the data line and the connection line GL are short-circuited, and the data line connected to the defective pixel may be electrically connected to the connection line GL.

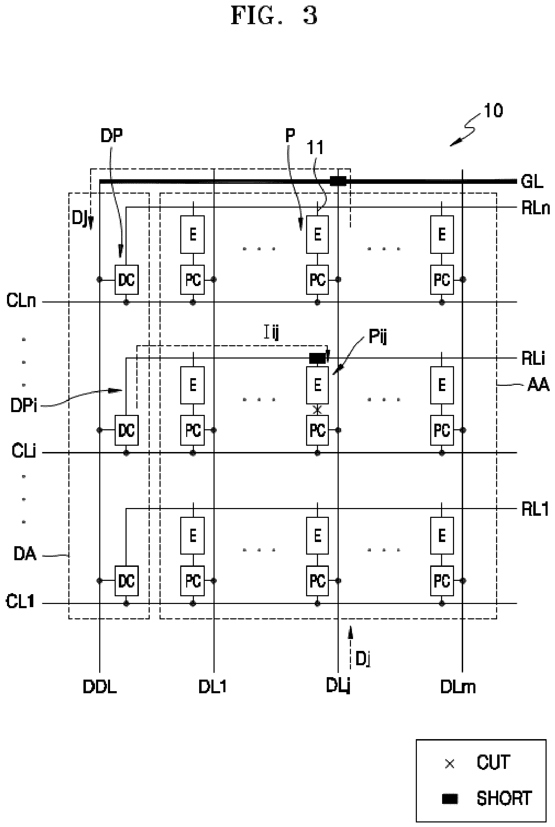

FIG. 3 is a view for explaining a method of repairing, by the display part 10 shown in FIG. 2, a defective pixel Pij using the repair line RLi.

Hereinafter, the case where, among the pixels P formed in the active area AA, a pixel Pij connected to an i-th control line CLi and a j-th data line DLj is defective, for example, a pixel circuit of the pixel Pij may be defective is described as an example. In the example, the pixel Pij may be denoted by a defective pixel Pij. The pixel Pij may be a pixel located in an i-th row and a j-th column.

Referring to FIG. 3, the light-emitting element E of the defective pixel Pij may be separated from the pixel circuit PC. As an example, the light-emitting element E of the defective pixel Pij may be separated from the pixel circuit PC by irradiating a laser beam to a connection region of the light-emitting element E and the pixel circuit PC to cut the connection region.

Next, the light-emitting element E of the defective pixel Pij may be electrically connected to the dummy circuit DC of a dummy pixel DPi. To accomplish this, the light-emitting element E of the defective pixel Pij may be connected to a repair line RLi in the same row. As an example, the light-emitting element E may be electrically connected to the repair line RLi by irradiating a laser beam to an overlapping region of the first connection member 11 connected to the light-emitting element E of the defective pixel Pij and the repair line RLi in the same row. Because the repair line RLi is connected to the dummy circuit DC, the light-emitting element E of the defective pixel Pij may be connected to the dummy circuit DC of the dummy pixel DPi.

Next, a data line DLj connected to the defective pixel Pij may be electrically connected to the dummy data line DDL. To accomplish this, the data line DLj may be connected to the connection line GL. As an example, the data line DLj may be electrically connected to the connection line GL by irradiating a laser beam to an overlapping region of the data line DLj and the connection line GL. Because the connection line GL may be connected to the dummy data line DDL, the data line DLj may be connected to the dummy data line DDL.

The pixel circuit PC of the defective pixel Pij and the dummy circuit DC of the dummy pixel DPi may be configured to simultaneously respond to a scan signal applied to the same scan line of the control line CLi. Because the data line DLj connected to the pixel circuit PC of the defective pixel Pij may be connected to the dummy data line DDL through the connection line GL, a data signal Dj applied to the pixel circuit PC of the defective pixel Pij may be also applied to the dummy circuit DC of the dummy pixel DPi. The dummy circuit DC may be configured to generate a driving current Iij corresponding to a data signal Dj and provide the driving current Iij to the light-emitting element E of the defective pixel Pij through the repair line RLi. The light-emitting element E of the defective pixel Pij may be configured to emit light at a brightness corresponding to a data signal Dj due to the driving current Iij. Through this, the defective pixel Pij may be repaired into a normal pixel.

In the embodiment, because the dummy data line DDL may be connected to the data line DLj through the connection line GL, the dummy data line DDL does not need to be driven separately. Accordingly, a separate timing or a source driver does not need to be changed to drive the dummy data line DDL, and an existing driver may be used as it is.

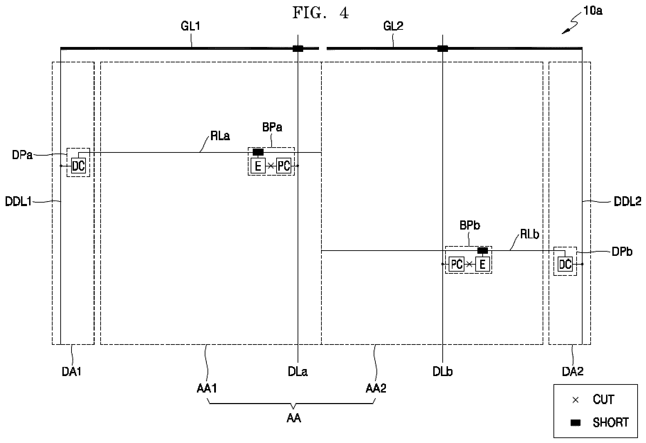

FIG. 4 is a schematic view of an example of the display part 10 shown in FIG. 1 according to an embodiment.

Referring to FIG. 4, a display part 10a may be substantially the same as the display part 10 shown in FIG. 2 except some differences. Hereinafter, repeated description of the same configuration is omitted, and differences are described. In addition, for understanding of the embodiment, a normal pixel P is not shown and only defective pixels BPa and BPb are shown and control lines are omitted in FIG. 4.

The display part 10a may include a first dummy area DA1 and a second dummy area DA2, wherein the first dummy area DA1 may be disposed on the left of the active area AA, and the second dummy area DA2 may be disposed on the right of the active area AA. A first dummy data line DDL1 and multiple first dummy pixels DPa connected thereto may be disposed in the first dummy area DA1. A second dummy data line DDL2 and multiple second dummy pixels DPb connected thereto may be disposed in the second dummy area DA2. The first dummy area DA1 and the second dummy area DA2 may correspond to the dummy area DA of FIG. 1.

The active area AA may be divided into a first active area AA1 and a second active area AA2. A first connection line GL1 connected to the first dummy data line DDL1 may be disposed on the upper side of the first active area AA1, and a second connection line GL2 connected to the second dummy data line DDL2 may be disposed on the upper side of the second active area AA2. The first connection line GL1 may be insulated from the second connection line GL2. The first connection line GL1 and the second connection line GL2 may be disposed on the lower side of the first active area AA1 and the second active area AA2, respectively. Data lines DLa in the first active area AA1 may be connectable to the first connection line GL1. Data lines DLb in the second active area AA2 may be connectable to the second connection line GL2.

The display part 10a may include first repair lines RLa and second repair lines RLb, wherein the first repair lines RLa extend from the first dummy pixels DPa in the first dummy area DA1 to the first active area AA1, and the second repair lines RLb extend from the second dummy pixels DPb in the second dummy area DA2 to the second active area AA2. The first repair lines RLa may be insulated from the second repair lines RLb.

At least one defective pixel BPa in the first active area AA1 may be repaired using the first repair lines RLa, the first connection lines GL1, and the first dummy data line DDL1. Multiple defective pixels BPa located in the same column may be repaired together even without an additional connection line and an additional dummy data line. The light-emitting element E of the defective pixel BPa in the first active area AA1 may be separated from the pixel circuit PC and connected to the dummy circuit DC of the first dummy pixel DPa in the same row through the first repair line RLa. The data line DLa connected to the defective pixel BPa may be connected to the first connection line GL1, and a data signal applied to the data line DLa may be also applied to the dummy circuit DC. The dummy circuit DC may be configured to generate the driving current corresponding to a data signal and provide the driving current to the light-emitting element E of the defective pixel BPa through the first repair line RLa, and the light-emitting element E may be configured to emit light according to the driving current.

At least one defective pixel BPb in the second active area AA2 may be repaired using the second repair lines RLb, the second connection lines GL2, and the second dummy data line DDL2. The light-emitting element E of the defective pixel BPb in the second active area AA2 may be separated from the pixel circuit PC and connected to the dummy circuit DC of the second dummy pixel DPb in the same row through the second repair line RLb. The data line DLb connected to the defective pixel BPb may be connected to the second connection line GL2, and a data signal applied to the data line DLb may be also applied to the dummy circuit DC. The dummy circuit DC may be configured to generate the driving current corresponding to a data signal and provide the driving current to the light-emitting element E of the defective pixel BPb through the second repair line RLb, and the light-emitting element E may be configured to emit light according to the driving current.

According to the embodiment, at least one defective pixel BPa in the first active area AA1 and at least one defective pixel BPb in the second active area AA2 may be repaired. Furthermore, according to the embodiment, even though two defective pixels occur in the same row, the two defective pixels may be repaired.

The above embodiments have described, as an example, the repairing in which the defective pixel and the dummy pixel DP in the same row may be connected by the repair line in the same row. However, the disclosure is not limited thereto and may be equally applicable to the case where the defective pixel may be connected to the dummy pixel DP in a different row by the repair line in the same row.

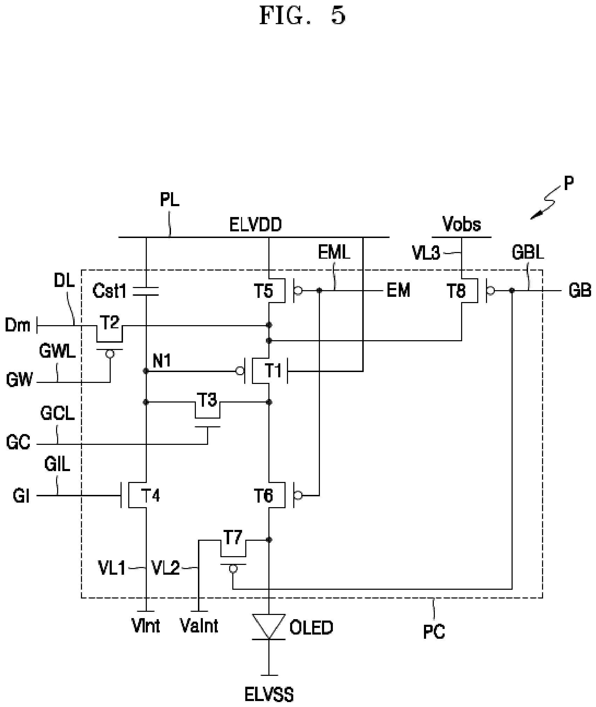

FIG. 5 is a schematic diagram of an equivalent circuit P of a pixel according to an embodiment. FIG. 5 shows a schematic diagram of an equivalent circuit of a pixel P among multiple pixels P as an example. As an example, a pixel P of FIG. 5 may be a pixel Pij (see FIG. 3) in an i-th row and a j-th column.

Referring to FIG. 5, the pixel P may be connected to a scan line GWL, a first initialization control line GIL, a second initialization control line GBL, a compensation scan line GCL, and an emission control line EML to receive a scan signal GW, a first initialization control signal GI, a second initialization control signal GB, a compensation scan signal GC, and an emission control signal EM, respectively. As an example, the scan line GWL, the first initialization control line GIL, the second initialization control line GBL, the compensation scan line GCL, and the emission control line EML of FIG. 5 may be signal lines corresponding to a pixel P in an i-th row.

The pixel P may be configured to receive a data signal Dm through the data line DL. As an example, the data line DL of FIG. 5 may be a data line corresponding to the pixel Pij (see FIG. 3) in a j-th column.

A pixel P of the display apparatus according to the embodiment may include the pixel circuit PC and an organic light-emitting element OLED as the light-emitting element E (see FIG. 2), wherein the organic light-emitting element OLED may be connected to the pixel circuit PC and configured to emit light. The organic light-emitting element OLED may include a pixel electrode (an anode), an opposite electrode (a cathode), and an emission layer between the anode and the cathode.

Hereinafter, although an organic light-emitting display apparatus including the organic light-emitting element OLED may be described as an example of the display apparatus 1 (see FIG. 1) according to an embodiment, the display apparatus 1 according to the disclosure is not limited thereto. In an embodiment, the display apparatus 1 according to the disclosure may be an inorganic light-emitting display apparatus or a quantum-dot light-emitting display apparatus. As an example, the emission layer of the light-emitting element E (see FIG. 2) of the display apparatus 1 may include an organic material or an inorganic material. The display apparatus 1 may include the emission layer and a quantum-dot layer disposed on a path of light emitted from the emission layer.

The pixel circuit PC may include multiple transistors T1, T2, T3, T4, T5, T6, T7, and T8, and a storage capacitive element. The transistors T1, T2, T3, T4, T5, T6, T7, and T8 may include a driving transistor T1, a switching transistor T2, a compensation transistor T3, a first initialization transistor T4, an operation control transistor T5, an emission control transistor T6, a second initialization transistor T7, and a bias transistor T8. The storage capacitive element may be a capacitor, and the storage capacitive element in the specification may be expressed by a first storage capacitor Cst1.

In an embodiment, some of the transistors T1, T2, T3, T4, T5, T6, T7, and T8 may be p-channel metal-oxide semiconductor (PMOS) field-effect transistors (p-channel MOSFET) and the rest may be n-channel metal-oxide semiconductor (NMOS) field-effect transistors (n-channel MOSFET). As an example, among the transistors T1, T2, T3, T4, T5, T6, T7, and T8, the driving transistor T1, the switching transistor T2, the operation control transistor T5, the emission control transistor T6, the second initialization transistor T7, the bias transistor T8 may be PMOSFETs, the compensation transistor T3, and the first initialization transistor T4 may be NMOSFETs. For example, among the transistors T1, T2, T3, T4, T5, T6, T7, and T8, the compensation transistor T3 and the first initialization transistor T4 may be PMOSFETs, and the rest may be NMOSFETs. For example, all of the transistors T1, T2, T3, T4, T5, T6, T7, and T8 may be NMOSFETs or PMOSFETs. Hereinafter, for convenience of description, the case where the compensation transistor T3 and the first initialization transistor T4 may be NMOSFETs including an oxide semiconductor, and the rest may be PMOSFETs, may be described.

At least one of the transistors T1, T2, T3, T4, T5, T6, T7, and T8 may be a transistor having a low-temperature polycrystalline silicon (LTPS) semiconductor layer, and at least one of the transistors T1, T2, T3, T4, T5, T6, T7, and T8 may be a transistor having an oxide semiconductor layer.

The driving transistor T1 influencing (e.g., directly influencing) the brightness of the display apparatus may be configured to include a semiconductor layer including polycrystalline silicon having high reliability, and thus, a high-resolution display apparatus may be implemented through this configuration. Because an oxide semiconductor has high carrier mobility and a low leakage current, a voltage drop is not large even in case that a driving time is long. For example, because a color change of an image according to a voltage drop may not be large even while the display apparatus is driven in low frequencies, the display apparatus may be driven in low frequencies. Because the oxide semiconductor has an advantage of a low leakage current, at least one of the compensation transistor T3 and the first initialization transistor T4 connected to a driving gate electrode of the driving transistor T1 may include an oxide semiconductor, and thus, a leakage current that may flow to the driving gate electrode may be prevented, and simultaneously, power consumption may be reduced. As an example, the driving transistor T1, the switching transistor T2, the operation control transistor T5, the emission control transistor T6, the second initialization transistor T7, and the bias transistor T8 may be transistors having a low-temperature polycrystalline silicon (LTPS) semiconductor layer, and the compensation transistor T3 and the first initialization transistor T4 may be transistors having an oxide semiconductor layer.

The driving transistor T1 may be electrically connected between a driving voltage line PL configured to receive a driving voltage ELVDD and the organic light-emitting element OLED. The gate electrode of the driving transistor T1 may be connected to an end (e.g., single end) of the first storage capacitor Cst1. The gate electrode of the driving transistor T1 may be connected to a first node N1. A source electrode of the driving transistor T1 may be connected to the driving voltage line PL through the operation control transistor T5. A drain electrode of the driving transistor T1 may be electrically connected to an anode of the organic light-emitting element OLED through the emission control transistor T6. The driving transistor T1 may be configured to receive a data signal Dm transferred by the data line DL and supply the driving current to the organic light-emitting diode OLED according to a switching operation of the switching transistor T2.

A gate electrode of the switching transistor T2 may be connected to the scan line GWL. A first electrode of the switching transistor T2 may be connected to the data line DL, and a second electrode may be connected to the source electrode of the driving transistor T1. The switching transistor T2 may be turned on according to a scan signal GW transferred through the scan line GWL and configured to transfer a data signal Dm transferred to the data line DL to the source electrode of the driving transistor T1, and a data signal Dm may be transferred to the gate electrode of the driving transistor T1 by the compensation transistor T3 that may be simultaneously turned on.

A gate electrode of the compensation transistor T3 may be connected to the compensation scan line GCL. A first electrode of the compensation transistor T3 may be connected to the drain electrode of the driving transistor T1, and a second electrode may be connected to the first node N1. The compensation transistor T3 may be turned on according to a compensation scan signal GC transferred through the compensation scan line GCL and configured to compensate for a threshold voltage (Vth) of the driving transistor T1 by connecting the gate electrode and the drain electrode of the driving transistor T1 to each other, thereby diode-connecting the driving transistor T1.

A gate electrode of the first initialization transistor T4 may be connected to the first initialization control line GIL. A first electrode of the first initialization transistor T4 may be connected to a first initialization voltage line VL1, and a second electrode may be connected to the first node N1. The first initialization transistor T4 may be turned on according to a first initialization control signal GI applied from the first initialization control line GIL and configured to initialize the electric potential (for example, the electric potential of the first node N1) of the gate electrode of the first transistor T1 to a preset voltage by transferring the first initialization voltage Vint to the gate electrode of the driving transistor T1. The first initialization voltage Vint may be set to the common voltage ELVSS or a voltage greater than the common voltage ELVSS.

A gate electrode of the operation control transistor T5 may be connected to the emission control line EML. A first electrode of the operation control transistor T5 may be connected to the driving voltage line PL, and a second electrode may be connected to the source electrode of the driving transistor T1.

A gate electrode of the emission control transistor T6 may be connected to the emission control line EML. A first electrode of the emission control transistor T6 may be connected to the drain electrode of the driving transistor T1, and a second electrode may be connected to the anode of the organic light-emitting element OLED. The operation control transistor T5 and the emission control transistor T6 may be simultaneously turned on according to an emission control signal EM applied from the emission control line EML. The driving voltage ELVDD applied through the turned-on operation control transistor T5 may be compensated for by the driving transistor T1 and then transferred to the organic light-emitting element OLED.

A gate electrode of the second initialization transistor T7 may be connected to the second initialization control line GBL. A first electrode of the second initialization transistor T7 may be connected to the anode of the organic light-emitting element OLED, and a second electrode may be connected to a second initialization voltage line VL2. The second initialization transistor T7 may be turned on according to a second initialization control signal GB applied from the second initialization control line GBL and configured to initialize the anode of the organic light-emitting element OLED. A second initialization control signal GB may be the same as or different from a first initialization control signal GI.

Unlike the disclosure, in case that the organic light-emitting element OLED is configured to emit light even in the case where a minimum current of the driving transistor T1 that displays a black image flows as the driving current, the black image may not be properly displayed. However, according to the disclosure, the second initialization transistor T7 may be configured to disperse, as a bypass current, a portion of the minimum current of the driving transistor T1 to another current path other than a current path toward the organic light-emitting element OLED. Here, the minimum current of the driving transistor T1 may denote a current under the condition that a gate-source voltage (Vgs) of the driving transistor T1 may be less than a threshold voltage (Vth) and thus the driving transistor T1 is turned off. The minimum driving current (e.g., a current less than 10 picoampere (pA)) under the condition that the driving transistor T1 is turned off may be transferred to the organic light-emitting element OLED and expressed as an image of black brightness. In case that the minimum driving current for displaying a black image flows, the bypass current has a large influence on the bypass transfer, whereas in case that a large driving current for displaying an image such as a normal image or a white image flows, the bypass current has little influence. Accordingly, in case that a driving current for displaying a black image flows, an accurate black-brightness image may be implemented using the first initialization transistor T7 based on the driving current, and thus, a contrast ratio may be improved. Accordingly, the display apparatus with an improved display quality may be provided.

A gate electrode of the bias transistor T8 may be connected to the second initialization control line GBL. A first electrode of the bias transistor T8 may be connected to a bias voltage line VL3 to which the bias voltage Vobs may be provided, and a second electrode of the bias transistor T8 may be connected to the source electrode of the driving transistor T1.

An end (e.g., single end) of the first storage capacitor Cst1 may be connected to the gate electrode of the driving transistor T1, and another end of the first storage capacitor Cst1 may be connected to the driving voltage line PL. The first storage capacitor Cst1 may be connected between the driving voltage line PL and the first node N1. A voltage between the driving voltage ELVDD and the first node N1 may be stored in the first storage capacitor Cst1.

The anode of the organic light-emitting element OLED may be connectable to the repair line and separable from the pixel circuit PC. A cathode of the organic light-emitting element OLED may be connected to a common voltage line configured to apply the common voltage ELVSS. The organic light-emitting element OLED may be configured to display images by receiving the driving current from the driving transistor T1 and emitting light. The driving voltage ELVDD may be a preset high-level voltage, and the common voltage ELVSS may be a ground voltage or a voltage less than the driving voltage ELVDD.

Hereinafter, an operating process of the pixel P is described. During an initialization period, a first initialization control signal GI of a high level may be supplied to the first initialization transistor T4 through the first initialization control line GIL, and a second initialization control signal GB of a low level may be supplied to the seventh initialization transistor T7 through the second initialization control line GBL. As a result, the first initialization transistor T4 and the seventh initialization transistor T7 may each be turned on. The first initialization voltage Vint applied from the first initialization voltage line VL1 may be transferred to the gate electrode of the driving transistor T1 through the first initialization transistor T4 and the second initialization voltage Vaint applied from the second initialization voltage line VL2 may be transferred to the anode of the light emitting element OLED through the second initialization transistor T7. Accordingly, the voltages of the gate electrode of the driving transistor T1 and the anode may be initialized.

Next, during a data-write period, a scan signal GW of a low level may be supplied through the scan line GWL so that the switching transistor T2 may be turned on. A compensation scan signal GC may be supplied through the compensation scan line GCL so that the compensation transistor T3 may be turned on. The switching transistor T2 may be configured to transfer a data signal Dm from the data line DL to the source electrode of the driving transistor T1, and the driving transistor T1 may be diode-connected by the compensation transistor T3. Then, a compensated voltage reduced from a data signal Dm by the threshold voltage of the driving transistor T1 may be applied to the gate electrode of the driving transistor T1.

The driving voltage ELVDD and the compensated voltage may be applied to two opposite ends of the first storage capacitor Cst1, and charge corresponding to a difference between voltages of the two opposite ends may be stored in the first storage capacitor Cst1.

Next, during an emission period, an emission control signal EM supplied from the emission control line EML may be changed from a high level to a low level, and the operation control transistor T5 and the emission control transistor T6 may be turned on. Then, the driving current corresponding to a voltage difference between the voltage of the gate electrode of the driving transistor T1 and the driving voltage ELVDD may occur, and the driving current may be supplied to the organic light-emitting element OLED through the emission control transistor T6, and the organic light-emitting element OLED may be configured to emit light.

The characteristic of the driving transistor T1 and the characteristic of the light-emitting element may be different for each of the pixels P. Particularly, while the display apparatus 1 may be driven at high frequencies, color coordinates of the display apparatus 1 may change (e.g., reddish). However, according to an embodiment, the voltage of the source electrode of the driving transistor T1 may be controlled by the bias voltage Vobs through the bias transistor T8. Deviation in brightness (deviation in current) for each pixel and a change of color coordinates may be reduced by controlling the driving current through this. Accordingly, the display apparatus 1 with improved display quality may be provided.

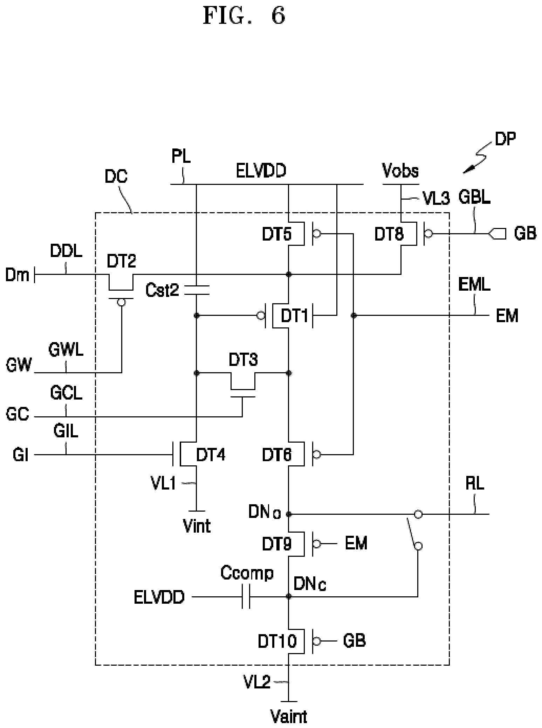

FIG. 6 is a schematic diagram of an equivalent circuit of a dummy pixel DP according to an embodiment. The dummy pixel DP of FIG. 6 shows, as an example, a dummy pixel DP connected to the pixel P of FIG. 5 by the repair line among the dummy pixels DP. As an example, the dummy pixel DP of FIG. 6 may be a dummy pixel in an i-th row.

The dummy pixel DP of FIG. 6 may be a dummy pixel in an i-th row. The dummy pixel DP may be connected to a scan line GWL, a first initialization control line GIL, an emission control line EML each corresponding to an i-th row to receive a scan signal GW, a first initialization control signal GI, and an emission control signal EM, respectively.

Referring to FIG. 6, the dummy pixel DP may be connected to the scan line GWL, the first initialization control line GIL, the second initialization control line GBL, the compensation scan line GCL, and the emission control line EML to receive a scan signal GW, a first initialization control signal GI, a second initialization control signal GB, a compensation scan signal GC, and an emission control signal EM, respectively. As an example, the scan line GWL, the first initialization control line GIL, the second initialization control line GBL, the compensation scan line GCL, and the emission control line EML of FIG. 6 may be signal lines corresponding to a pixel P in an i-th row.

The dummy pixel DP may be configured to receive a data signal Dm through the dummy data line DDL. As an example, the dummy data line DDL of FIG. 6 may be connected to a data line DLj (see FIG. 1) corresponding to the pixel Pij (see FIG. 3) in a j-th column.

The dummy pixel DP may include a dummy circuit DC. The dummy circuit DC may include multiple transistors DT1, DT2, DT3, DT4, DT5, DT6, DT7, DT8, DT9, and DT10, a storage capacitive element, and a compensation capacitive element. The transistors DT1, DT2, DT3, DT4, DT5, DT6, DT8, DT9, and DT10 of the dummy circuit DC may include a driving transistor DT1, a switching transistor DT2, a compensation transistor DT3, a first initialization transistor DT4, an operation control transistor DT5, an emission control transistor DT6, a bias transistor DT8, a capacitance control transistor DT9, and a capacitive element initialization transistor DT10. A storage capacitive element and a compensation capacitive element may be capacitors. In the specification, the storage capacitive element may be expressed by a second storage capacitor Cst2, and the compensation capacitive element may be expressed by a compensation capacitor Ccomp. Elements of the dummy circuit DC may be different from elements of the pixel circuit PC (see FIG. 5) in size and capacity.

The dummy circuit DC of the dummy pixel DP may be mostly equal to the pixel circuit PC of the pixel P shown in FIG. 5 except some differences. Hereinafter, repeated description of the same configuration is omitted, and differences are described.

A gate electrode of the capacitance control transistor DT9 may be connected to the emission control line EML to receive an emission control signal EM. A first electrode of the capacitance control transistor DT9 may be connected to the repair line RL through an output node DNo, and a second electrode thereof may be connected to a compensation node DNc. The capacitance control transistor DT9 may be turned on according to an emission control signal EM and configured to supply charge stored in the compensation capacitor Ccomp to the repair line RL.

A gate electrode of the capacitive element initialization transistor DT10 may be connected to the second initialization control line GBL to receive a second initialization control signal GB. A first electrode of the capacitive element initialization transistor DT10 may be connected to the compensation node DNc, and a second electrode thereof may be connected to the second initialization voltage line VL2. The capacitive element initialization transistor DT10 may be turned on according to a second initialization control signal GB to supply the second initialization voltage Vaint to the compensation capacitor Ccomp such that the compensation capacitor Ccomp may be charged with charge corresponding to a difference between the driving voltage ELVDD and the second initialization voltage Vaint.

The driving voltage ELVDD and the voltage of the compensation node DNc may be applied to two opposite ends of the compensation capacitor Ccomp, and charge corresponding to a difference between voltages of the two opposite ends may be stored in the compensation capacitor Ccomp.

The dummy pixel DP may not include the organic light-emitting element OLED. However, the dummy pixel DP may include a light-emitting element depending on design. In the case where the dummy pixel DP includes a light-emitting element, the light-emitting element does not actually emit light but may serve as a circuit element. As an example, the light-emitting element may serve as one of capacitors included in the dummy pixel DP.

Hereinafter, an operating process of the dummy pixel DP is described. During an initialization period, a first initialization control signal GI of a high level may be supplied to the first initialization transistor DT4 through the first initialization control line GIL, and a second initialization control signal GB of a low level may be supplied to the capacitive element initialization transistor DT10 through the second initialization control line GBL. As a result, the first initialization transistor DT4 and the capacitive element initialization transistor DT10 may each be turned on. The first initialization voltage Vint applied from the first initialization voltage line VL1 may be transferred to the gate electrode of the driving transistor DT1 through the first initialization transistor DT4, and the second initialization voltage Vaint applied from the second initialization voltage line VL2 may be transferred to the anode (or an electrode of the compensation capacitor Ccomp) through the capacitive element initialization transistor DT10. Accordingly, the gate electrode of the driving transistor DT1 may be initialized, and the compensation capacitor Ccomp may be charged with charge corresponding to a difference between the driving voltage ELVDD and the second initialization voltage Vaint.

Next, during a data-write period, a scan signal GW of a low level may be supplied through the scan line GWL and a compensation scan signal GC of a high level may be supplied through the compensation scan line GCL so that the switching transistor DT2 and the compensation transistor DT3 may be turned on. The switching transistor DT2 may be configured to transfer a data signal Dm from the dummy data line DDL to the source electrode of the driving transistor DT1, and the driving transistor DT1 may be diode-connected by the compensation transistor DT3. Then, a compensated voltage, reduced from a data signal Dm by the threshold voltage of the driving transistor DT1, may be applied to the gate electrode of the driving transistor DT1.

The driving voltage ELVDD and the compensated voltage may be applied to two opposite ends of the second storage capacitor Cst2, and a charge corresponding to a difference between voltages of the two opposite ends may be stored in the second storage capacitor Cst2.

Next, during an emission period, an emission control signal EM supplied from the emission control line EML may be changed from a high level to a low level, and the operation control transistor DT5 and the emission control transistor DT6 may be turned on. Then, the driving current corresponding to a voltage difference between the voltage of the gate electrode of the driving transistor DT1 and the driving voltage ELVDD may occur, and the driving current may be supplied to the organic light-emitting element OLED of a repair pixel along the repair line RL through the emission control transistor DT6. The current supplied to the organic light-emitting element OLED of the repair pixel may be increased or reduced by the charge charged in the compensation capacitor Ccomp. For example, in case that an emission control signal EM changes from a high level to a low level, the capacitance control transistor DT9 may be turned on, energy due to the charge stored in the compensation capacitor Ccomp may be supplied to the output node DNo, and an amount of current supplied through the repair line RL may change due to the potential change of the output node DNo.

The voltage of the source electrode of the driving transistor DT1 may be controlled by the bias voltage Vobs through the bias transistor DT8. Deviation in brightness (deviation in current) for each pixel and a change of color coordinates may be reduced by controlling the driving current through this.

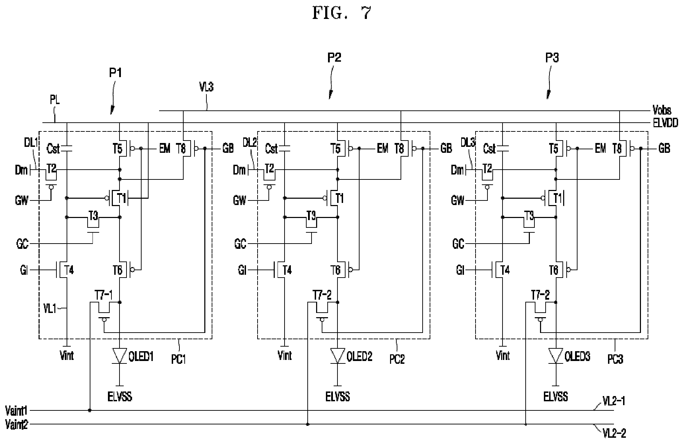

FIG. 7 is a schematic diagram of an equivalent circuit of some pixels P1, P2, and P3 according to an embodiment. The pixels P may include a first pixel P1, a second pixel P2, and a third pixel P3 configured to emit light of different colors. FIG. 7 is a schematic diagram of an equivalent circuit of the first pixel P1, the second pixel P2, and the third pixel P3 configured to emit light of different colors. In describing FIG. 7, the same descriptions as those of the elements of FIG. 5 are omitted, and differences are described.

Referring to FIG. 7, the first pixel P1, the second pixel P2, and the third pixel P3 may share one of the control lines CL1 to CLn (see FIG. 1). The first pixel P1 may be electrically connected to a first data line DL1 which may be one of the data lines DL1 to DLm. The second pixel P2 may be electrically connected to a second data line DL2 which may be another of the data lines DL1 to DLm. The third pixel P3 may be electrically connected to a third data line DL3 which may be another of the data lines DL1 to DLm.

The first pixel P1 may include a first pixel circuit PC1 and a first organic light-emitting element OLED1. A second-1 initialization transistor T7-1 of the first pixel circuit PC1 may be connected between a second-1 initialization voltage line VL2-1 and an anode of the first organic light-emitting element OLED1 and may be configured to receive a second initialization control signal GB. The first pixel P1 may be configured to emit light of a first color. As an example, the light of the first color may be red light.

The second pixel P2 may include a second pixel circuit PC2 and a second organic light-emitting element OLED2. A second-2 initialization transistor T7-2 of the second pixel circuit PC2 may be connected between a second-2 initialization voltage line VL2-2 and an anode of the second organic light-emitting element OLED2 and may be configured to receive a second initialization control signal GB. The second pixel P2 may be configured to emit light of a second color different from the first color. As an example, the light of the second color may be green light.

The third pixel P3 may include a third pixel circuit PC3 and a third organic light-emitting element OLED3. A second-2 initialization transistor T7-2 of the third pixel circuit PC3 may be connected between the second-2 initialization voltage line VL2-2 and an anode of the third organic light-emitting element OLED3 and may be configured to receive a second initialization control signal GB. The third pixel P3 may be configured to emit light of a third color different from the first color and the second color. As an example, the light of the third color may be blue light.

A second-1 initialization voltage Vaint1 may be applied to the second-1 initialization voltage line VL2-1. A second-2 initialization voltage Vaint2 may be applied to the second-2 initialization voltage line VL2-2. The second-1 initialization voltage Vaint1 may have a lower level than the second-2 initialization voltage Vaint2. As an example, the second-1 initialization voltage Vaint1 may be about 0.3 V (volt), and the second-2 initialization voltage Vaint2 may be about 1.5 V.

The second-1 initialization voltage line VL2-1 to which the second-1 initialization voltage Vaint1 may be provided may be connected to the first pixel circuit PC1 of the first pixel P1. The first pixel circuit PC1 may be electrically connected to the first organic light-emitting element OLED1 configured to emit light of the first color. The second-2 initialization voltage line VL2-2 to which the second-2 initialization voltage Vaint2 having a higher voltage level than the second-1 initialization voltage Vaint1 may be provided may be connected to the second pixel circuit PC2 of the second pixel P2. The second pixel circuit PC2 may be electrically connected to the second organic light-emitting element OLED2 configured to emit light of the second color. The second-2 initialization voltage line VL2-2 to which the second-2 initialization voltage Vaint2 may be provided may be connected to the third pixel circuit PC3 of the third pixel P3. The third pixel circuit PC3 may be electrically connected to the third organic light-emitting element OLED3 configured to emit light of the third color. For example, the initialization voltages Vaint1 and Vaint2 may be provided differently depending on the kind of pixel.

Although it is shown in FIG. 7 that the first pixel circuit PC1 may be connected to the second-1 initialization voltage line VL2-1, and the second pixel circuit PC2 and the third pixel circuit PC3 may be connected to the second-2 initialization voltage line VL2-2, the initialization voltage provided to each of the first pixel circuit PC1, the second pixel circuit PC2, and the third pixel circuit PC3 according to an embodiment is not limited thereto. As an example, different initialization voltage lines may be respectively connected to the first pixel circuit PC1, the second pixel circuit PC2, and the third pixel circuit PC3, and different initialization voltages may be provided thereto.

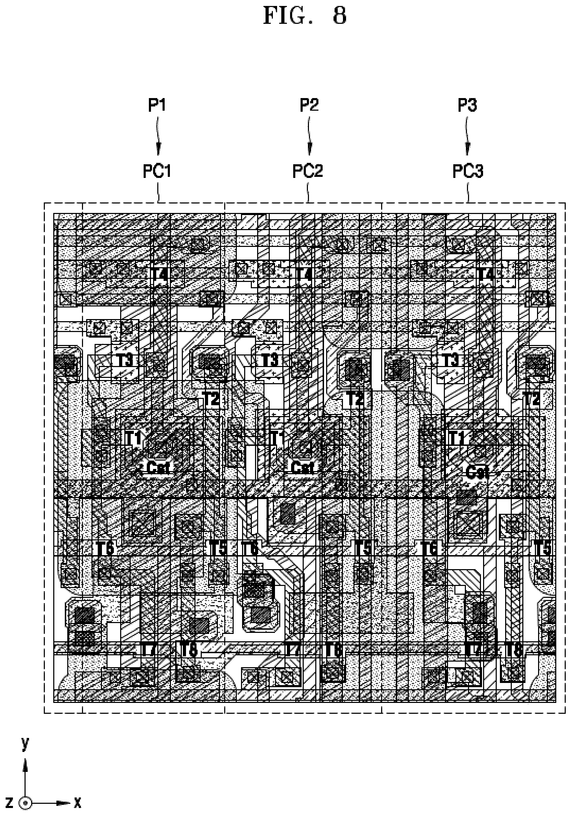

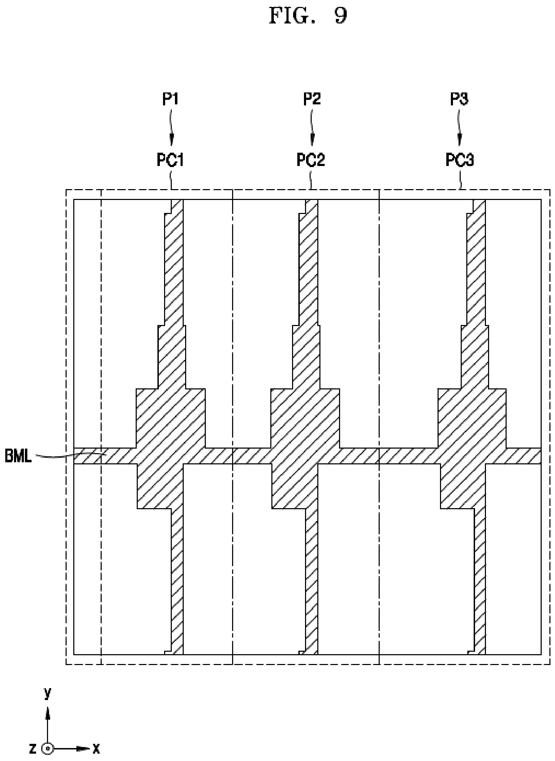

FIG. 8 is a schematic configuration view of the positions of transistors and a capacitor in pixels of a display apparatus according to an embodiment, for example, FIG. 8 is a schematic configuration view showing the positions of the transistors T1, T2, T3, T4, T5, T6, T7, and T8, and the storage capacitor Cst in each of the pixels included in the display apparatus 1 of FIG. 1. FIGS. 9 to 19 are schematic configuration views of elements such as transistors, a capacitor, and the like, of a display apparatus 1 shown in FIG. 8, for respective layer, such as the transistors T1, T2, T3, T4, T5, T6, T7, and T8, the storage capacitor Cst, and the like of the display apparatus 1 shown in FIG. 8.

As shown in FIGS. 8 to 19, the display apparatus 1 may include the first pixel P1, the second pixel P2, and the third pixel P3. The first pixel P1 may include the first pixel circuit PC1, the second pixel P2 may include the second pixel circuit PC2, and the third pixel P3 may include the third pixel circuit PC3. Hereinafter, for convenience of description, although some of conductive patterns may be described based on the first pixel circuit PC1, these elements may be disposed also in the second pixel circuit PC2 and the third pixel circuit PC3.

The structure shown in FIGS. 8 to 19 may be repeatedly disposed in the first direction (e.g., the x direction) and/or the second direction (e.g., the y direction).

FIG. 9 shows a bottom conductive layer BML.

Referring to FIGS. 8 and 9, a portion of the bottom conductive layer BML has a shape corresponding to the driving transistor T1 to serve as a bottom protective metal that protects a portion of a first semiconductor layer 1100 overlapping the bottom conductive layer BML. Because the bottom conductive layer BML includes a portion extending in the first direction and a portion extending in the second direction in each of the first to third pixels P1, P2, and P3, the bottom conductive layer BML in the first to third pixels P1, P2, and P3 may be integral with each other.

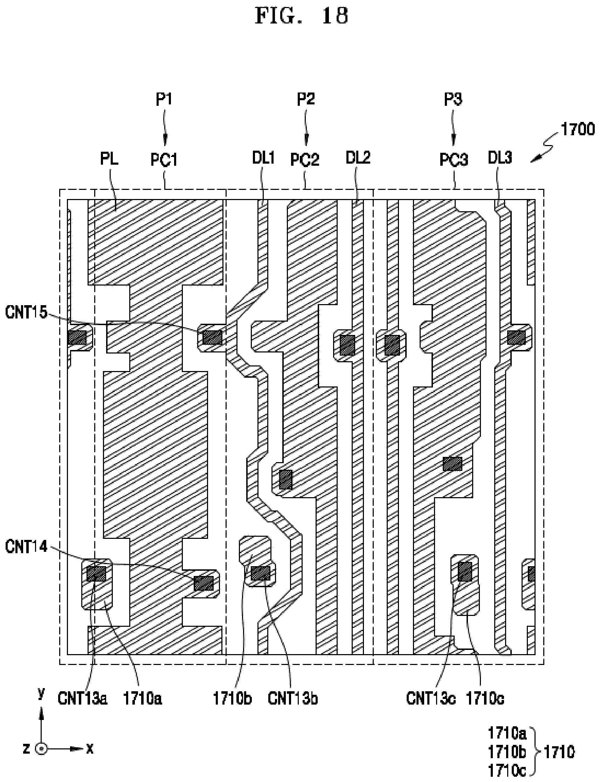

Because the bottom conductive layer BML may be electrically connected to the driving voltage line PL (see FIG. 18), an electrical signal equal to an electrical signal applied to the driving voltage line PL may be applied to the bottom conductive layer BML. For example, the driving voltage ELVDD applied to the driving voltage line PL may be also applied to the bottom conductive layer BML.

The bottom conductive layer BML may include metal, an alloy, a metal nitride, a conductive metal oxide, or a transparent conductive material, the like, or a combination thereof. As an example, the bottom conductive layer BML may include silver (Ag), an alloy containing silver, molybdenum (Mo), an alloy containing molybdenum, aluminum (Al), an alloy containing aluminum, aluminum nitride (AlN), tungsten (W ), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO) or indium zinc oxide (IZO), the like, or a combination thereof. The bottom conductive layer BML may have a multi-layered structure. As an example, the bottom conductive layer BML may have a two-layered structure of Mo/Al, or a three-layered structure of Mo/Al/Mo.

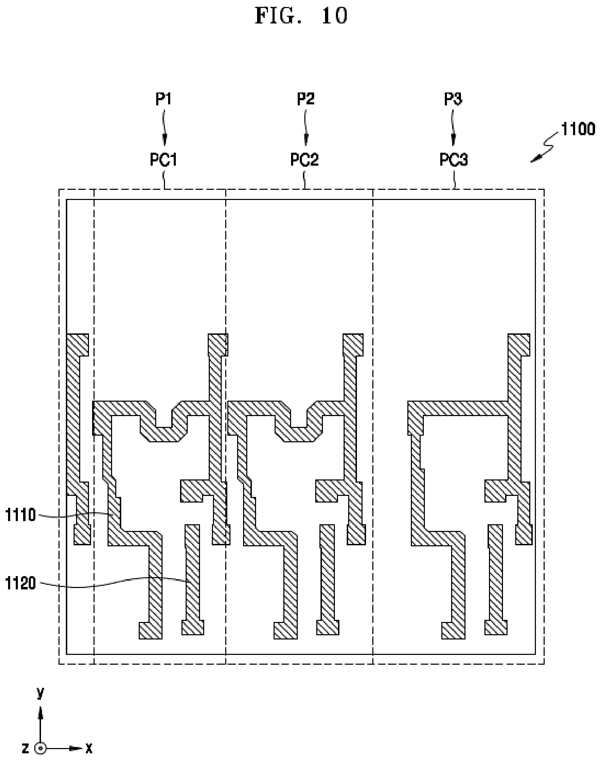

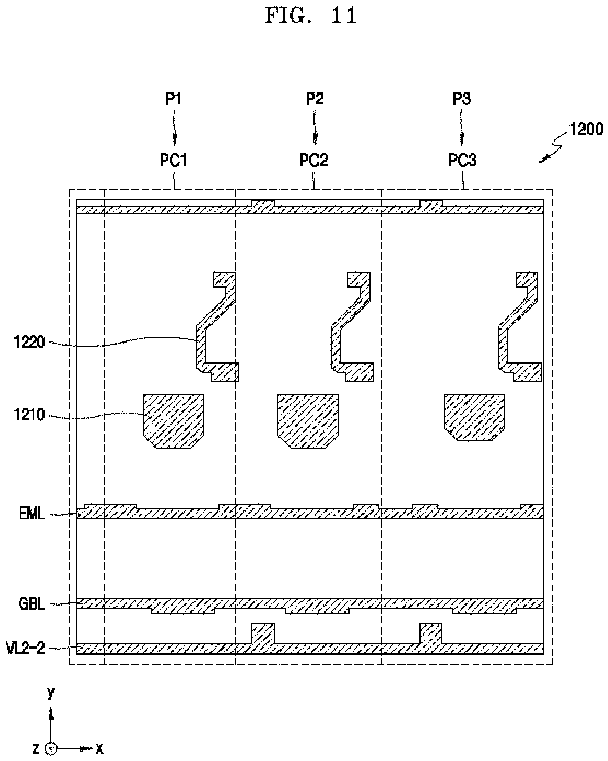

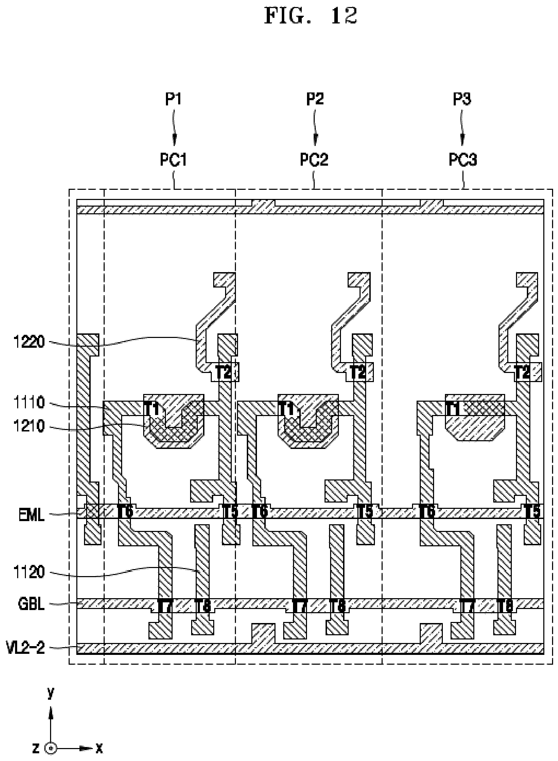

FIG. 10 shows the first semiconductor layer 1100 on the bottom conductive layer BML, and FIG. 11 shows a first conductive layer 1200 on the first semiconductor layer 1100. FIG. 12 shows the first semiconductor layer 1100 and the first conductive layer 1200 together and shows the configuration of the driving transistor T1, the switching transistor T2, the operation control transistor T5, the emission control transistor T6, the second initialization transistor T7, and the bias transistor T8.

Referring to FIG. 8 and FIGS. 10 to 12, the first semiconductor layer 1100 may include a first semiconductor pattern 1110 and a second semiconductor pattern 1120. For example, the first semiconductor pattern 1110 and the second semiconductor pattern 1120 may be disposed on a same layer. Each of the first semiconductor pattern 1110 and the second semiconductor pattern 1120 may be disposed for each pixel. As an example, each of the first semiconductor pattern 1110 and the second semiconductor pattern 1120 may be disposed one by one in each of the first pixel P1, the second pixel P2, and the third pixel P3.

The first semiconductor layer 1100 may include semiconductor layers of the driving transistor T1, the switching transistor T2, the operation control transistor T5, the emission control transistor T6, the second initialization transistor T7, and the bias transistor T8. The first semiconductor pattern 1110 may include the semiconductor layers of the driving transistor T1, the switching transistor T2, the operation control transistor T5, the emission control transistor T6, and the second initialization transistor T7. The second semiconductor pattern 1120 may include the semiconductor layer of the bias transistor T8.

The first semiconductor layer 1100 may include a silicon semiconductor material. As an example, the first semiconductor layer 1100 may include amorphous silicon or polycrystalline silicon. As an example, the first semiconductor layer 1100 may include polycrystalline silicon crystallized at low temperature. The first semiconductor layer 1100 may include a channel region, a drain region, and a source region, wherein the channel region overlaps a gate electrode, and the drain region and the source region may be on two opposite sides of the channel region. The source region and the drain region may each be regions doped with impurities.

The first conductive layer 1200 may be disposed on the first semiconductor layer 1100. The first conductive layer 1200 may include a first conductive pattern 1210, a second conductive pattern 1220, the emission control line EML, the second initialization control line GBL, and the second-2 initialization voltage line VL2-2. For example, the first conductive pattern 1210, the second conductive pattern 1220, the emission control line EML, the second initialization control line GBL, and the second-2 initialization voltage line VL2-2 may be disposed on a same layer. The first conductive layer 1200 may be denoted by a first gate layer.

Each of the first conductive pattern 1210 and the second conductive pattern 1220 may have an isolated shape. Each of the first conductive pattern 1210 and the second conductive pattern 1220 may be disposed for each pixel. As an example, each of the first conductive pattern 1210 and the second conductive pattern 1220 may be disposed one by one in each of the first pixel P1, the second pixel P2, and the third pixel P3.

The first conductive pattern 1210, the second conductive pattern 1220, the emission control line EML, and the second initialization control line GBL may overlap the first semiconductor layer 1100 to serve as a gate electrode of a transistor.

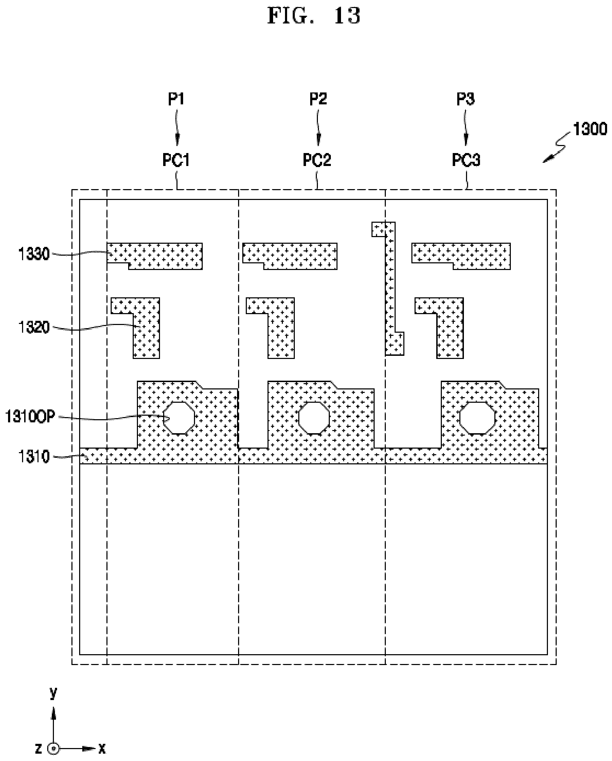

A portion of the first conductive pattern 1210 overlapping the first semiconductor pattern 1110 may be the gate electrode of the driving transistor T1. The first conductive pattern 1210 may overlap some electrodes of the second conductive layer 1300 (see FIG. 13) described below, and thus, form the storage capacitor Cst shown in FIG. 8. For example, the first conductive pattern 1210 may be an electrode (e.g., single electrode) of the storage capacitor Cst. As an example, the first conductive pattern 1210 may be a lower electrode of the storage capacitor Cst.

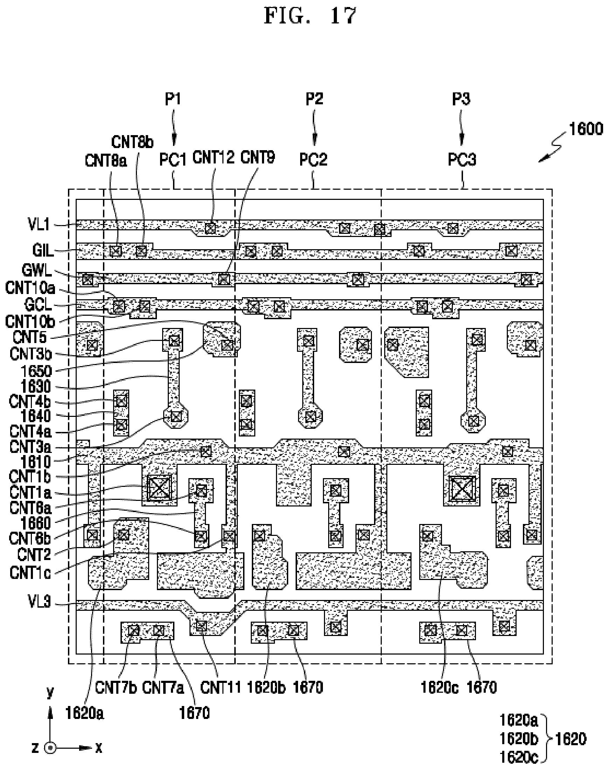

A portion of the second conductive pattern 1220 overlapping the first semiconductor pattern 1110 may be the gate electrode of the switching transistor T2. The second conductive pattern 1220 may be electrically connected to the scan line GWL (see FIG. 17) described below to receive a scan signal GW. For example, a scan signal GW may be applied to the pixels through the second conductive pattern 1220.

The emission control line EML, the second initialization control line GBL, and the second-2 initialization voltage line VL2-2 may each extend in the first direction (e.g., the x direction). The emission control line EML may be configured to transfer an emission control signal EM to each of the pixels. The second initialization control line GBL may be configured to transfer a second initialization control signal GB to each of the pixels. The second-2 initialization voltage line VL2-2 may be configured to transfer the second-2 initialization voltage Vaint2 to the second pixel P2 and the third pixel P3.

A portion of the emission control line EML overlapping the first semiconductor pattern 1110 may be the gate electrode of the operation control transistor T5, and another portion of the emission control line EML overlapping the first semiconductor pattern 1110 may be the gate electrode of the emission control transistor T6.

A portion of the second initialization control line GBL overlapping the first semiconductor pattern 1110 may be the gate electrode of the second initialization transistor T7.

In an embodiment, the second-1 initialization voltage Vaint1 may be transferred to the second initialization transistor T7 of the first pixel P1 by the second-1 initialization voltage line VL2-1 of a third conductive layer 1500 described below. In an embodiment, the second-2 initialization voltage Vaint2 may be transferred to the second initialization transistor T7 of the second pixel P2 by the second-2 initialization voltage line VL2-2 of the first conductive layer 1200. In an embodiment, the second-2 initialization voltage Vaint2 may be transferred to the second initialization transistor T7 of the third pixel P3 by the second-2 initialization voltage line VL2-2 of the first conductive layer 1200.

A portion of the second initialization control line GBL overlapping the second semiconductor pattern 1120 may be the gate electrode of the bias transistor T8.

The first conductive layer 1200 may include metal, an alloy, a metal nitride, a conductive metal oxide, or the like. As an example, the first conductive layer 1200 may include silver (Ag), an alloy containing silver, molybdenum (Mo), an alloy containing molybdenum, aluminum (Al), an alloy containing aluminum, aluminum nitride (AlN), tungsten (W ), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO) or indium zinc oxide (IZO), the like, or a combination thereof. The first conductive layer 1200 may have a multi-layered structure.

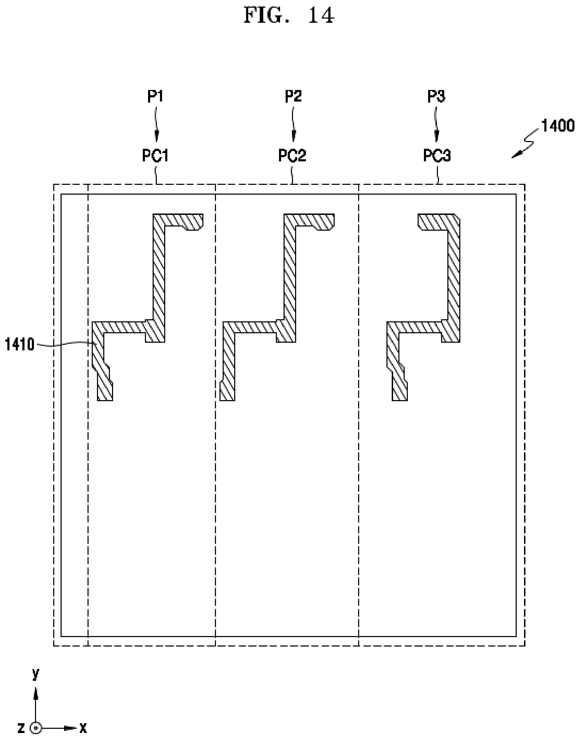

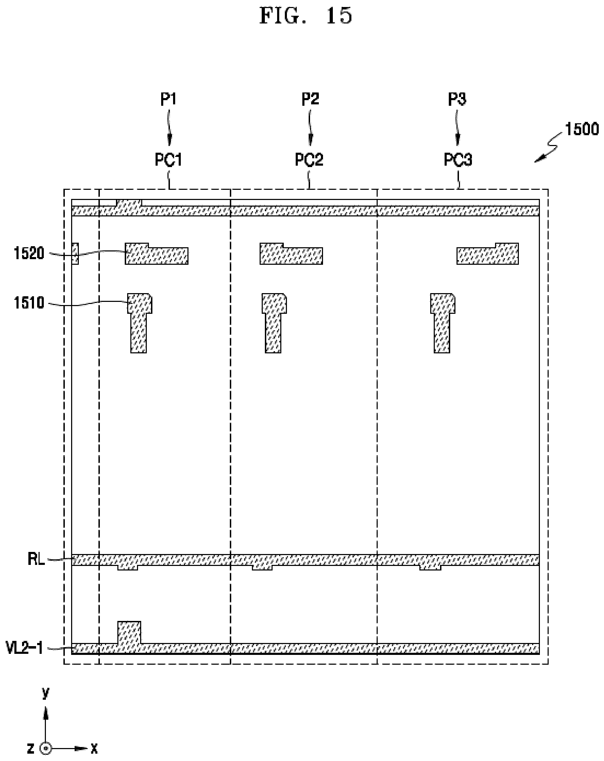

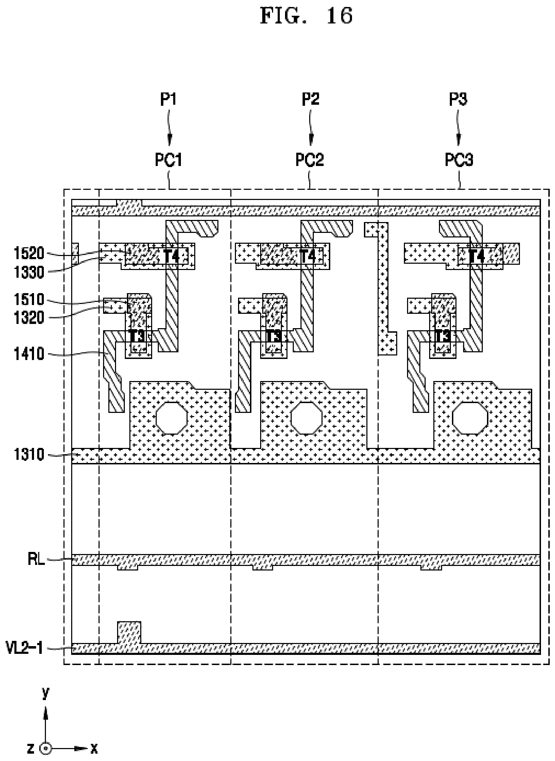

FIG. 13 shows the second conductive layer 1300 on the first conductive layer 1200, FIG. 14 shows the second semiconductor layer 1400 on the second conductive layer 1300, and FIG. 15 shows the third conductive layer 1500 on the second semiconductor layer 1400. FIG. 16 shows the second conductive layer 1300, the second semiconductor layer 1400, and the third conductive layer 1500 together to show the configuration of the compensation transistor T3 and the first initialization transistor T4.

Referring to FIG. 8 and FIGS. 13 to 16, the second conductive layer 1300 may include a third conductive pattern 1310, a fourth conductive pattern 1320, and a fifth conductive pattern 1330. For example, the third conductive pattern 1310, the fourth conductive pattern 1320, and the fifth conductive pattern 1330 may be disposed on a same layer. The second conductive layer 1300 may be denoted by a second gate layer.

The third conductive pattern 1310 may overlap the first conductive pattern 1210. The third conductive pattern 1310 may be disposed on the first conductive pattern 1210. In an embodiment, the third conductive pattern 1310 may overlap the first conductive patterns 1210 respectively disposed in the first to third pixels P1, P2, and P3 and be integrally provided in the first to third pixels P1, P2, and P3.

The third conductive pattern 1310 may overlap the first conductive pattern 1210 to form the storage capacitor Cst (see FIG. 8). For example, the third conductive pattern 1310 may be an electrode (e.g., single electrode) of the storage capacitor Cst shown in FIG. 8. As an example, the third conductive pattern 1310 may be an upper electrode of the storage capacitor Cst.

The third conductive pattern 1310 may have an opening 1310OP of a closed shape. The first conductive pattern 1210 may be electrically connected to a first connection electrode 1630 (see FIG. 17) described below through the opening 1310OP of the third conductive pattern 1310.

Each of the fourth conductive pattern 1320 and the fifth conductive pattern 1330 may have an isolated shape. Each of the fourth conductive pattern 1320 and the fifth conductive pattern 1330 may be disposed for each pixel. As an example, each of the fourth conductive pattern 1320 and the fifth conductive pattern 1330 may be disposed one by one in each of the first pixel P1, the second pixel P2, and the third pixel P3.

The fourth conductive pattern 1320 may be electrically connected to the compensation scan line GCL (see FIG. 17) described below. A compensation scan signal GC may be transferred to the fourth conductive pattern 1320 by the compensation scan line GCL. A portion of the fourth conductive pattern 1320 overlapping the third semiconductor pattern 1410 described below may be a lower gate electrode of the compensation transistor T3.

The fifth conductive pattern 1330 may be electrically connected to the first initialization control line GIL (see FIG. 17) described below. A first initialization control signal GI may be transferred to the fifth conductive pattern 1330 by the first initialization control line GIL. A portion of the fifth conductive pattern 1330 overlapping the third semiconductor pattern 1410 described below may be a lower gate electrode of the first initialization transistor T4.

The second conductive layer 1300 may include metal, an alloy, a metal nitride, a conductive metal oxide, or the like. As an example, the second conductive layer 1300 may include silver (Ag), an alloy containing silver, molybdenum (Mo), an alloy containing molybdenum, aluminum (Al), an alloy containing aluminum, aluminum nitride (AlN), tungsten (W ), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO) or indium zinc oxide (IZO), the like, or a combination thereof. The second conductive layer 1300 may have a multi-layered structure.

The second semiconductor layer 1400 may be disposed on the second conductive layer 1300. The second semiconductor layer 1400 may include the third semiconductor pattern 1410. The third semiconductor pattern 1410 may be disposed for each pixel. As an example, the third semiconductor pattern 1410 may be disposed one by one in each of the first pixel P1, the second pixel P2, and the third pixel P3. The third semiconductor pattern 1410 may include semiconductor layer of the compensation transistor T3 and the first initialization transistor T4.

The second semiconductor layer 1400 may include an oxide semiconductor material. As an example, the second semiconductor layer 1400 may include an oxide of at least one of indium (In), gallium (Ga), tin (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). As an example, the second semiconductor layer 1400 may be an ITZO (InSnZnO) semiconductor layer, an IGZO (InGaZnO) semiconductor layer and the like. Because an oxide semiconductor has a wide band gap (of about 3.1 eV), a high carrier mobility, and a low leakage current, a voltage drop may not be large even though a driving time may be long, and thus, the oxide semiconductor has an advantage that a brightness change due to a voltage drop may not be large even in case that the display apparatus is driven at low frequencies. The second semiconductor layer 1400 may include a channel region, a drain region, and a source region, wherein the channel region overlaps a gate electrode, and the drain region and the source region may be on two opposite sides of the channel region.

The third conductive layer 1500 may be disposed on the second semiconductor layer 1400. The third conductive layer 1500 may include a sixth conductive pattern 1510, a seventh conductive pattern 1520, the repair line RL, and the second-1 initialization voltage line VL2-1. For example, the sixth conductive pattern 1510, the seventh conductive pattern 1520, the repair line RL, and the second-1 initialization voltage line VL2-1 may be disposed on a same layer. The third conductive layer 1500 may be denoted by a third gate layer.

Each of the sixth conductive pattern 1510 and the seventh conductive pattern 1520 may have an isolated shape. Each of the sixth conductive pattern 1510 and the seventh conductive pattern 1520 may be disposed for each pixel. As an example, each of the sixth conductive pattern 1510 and the seventh conductive pattern 1520 may be disposed one by one in each of the first pixel P1, the second pixel P2, and the third pixel P3.

Each of the sixth conductive pattern 1510 and the seventh conductive pattern 1520 may overlap the second semiconductor layer 1400 to serve as a gate electrode of a transistor.

A portion of the sixth conductive pattern 1510 overlapping the third semiconductor pattern 1410 may be the gate electrode of the compensation transistor T3. As an example, a portion of the sixth conductive pattern 1510 overlapping the third semiconductor pattern 1410 may be an upper gate electrode of the compensation transistor T3. The sixth conductive pattern 1510 may be electrically connected to the compensation scan line GCL (see FIG. 17) described below to receive a compensation scan signal GC.

A portion of the seventh conductive pattern 1520 overlapping the third semiconductor pattern 1410 may be the gate electrode of the first initialization transistor T4. As an example, a portion of the seventh conductive pattern 1520 overlapping the third semiconductor pattern 1410 may be an upper gate electrode of the first initialization transistor T4. The seventh conductive pattern 1520 may be electrically connected to the first initialization control line GIL (see FIG. 17) described below to receive a first initialization control signal GI.

The repair line RL may extend in the first direction (e.g., the x direction). The repair line RL may be connected to the dummy pixel DP (see FIGS. 1 to 3) and may be connectable to a light-emitting element of a defective pixel among the pixels P. The repair line RL may overlap a first-1 pixel connection electrode 1620a electrically connected to a first pixel electrode 210a of the first pixel P1, a first-2 pixel connection electrode 1620b electrically connected to a second pixel electrode 210b of the second pixel P2, and a first-3 pixel connection electrode 1620c electrically connected to a third pixel electrode 210c of the third pixel P3. As an example, in the case where the first pixel P1 may be defective, the first-1 pixel connection electrode 1620a may be connected to the repair line RL by irradiating a laser beam to a region in which the first-1 pixel connection electrode 1620a overlaps the repair line RL, and the repair line RL may be electrically connected to the first pixel electrode 210a of the first pixel P1.

The second-1 initialization voltage line VL2-1 may extend in the first direction (e.g., the x direction). In an embodiment, the second-1 initialization voltage line VL2-1 may be configured to transfer the second-1 initialization voltage Vaint1 to the first pixel P1.

The third conductive layer 1500 may include metal, an alloy, a metal nitride, a conductive metal oxide, or the like. As an example, the third conductive layer 1500 may include silver (Ag), an alloy containing silver, molybdenum (Mo), an alloy containing molybdenum, aluminum (Al), an alloy containing aluminum, aluminum nitride (AlN), tungsten (W ), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO) or indium zinc oxide (IZO), the like, or a combination thereof. The third conductive layer 1500 may have a multi-layered structure.

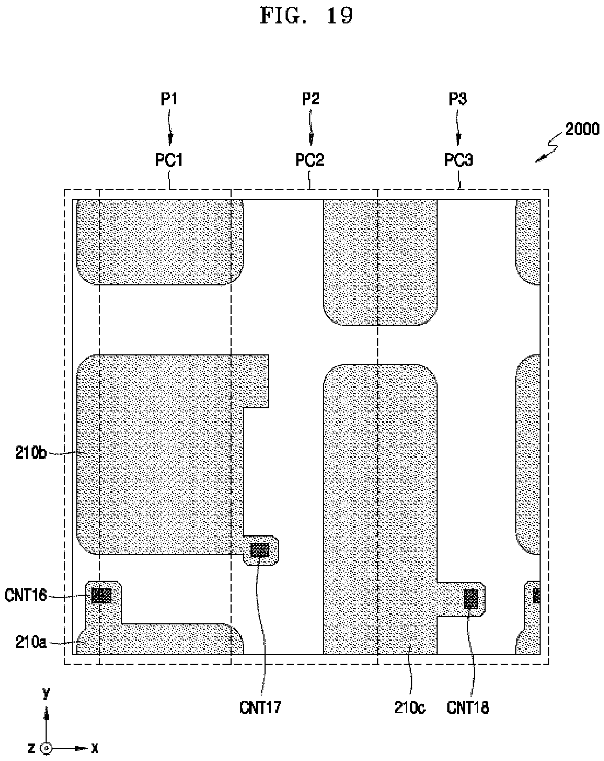

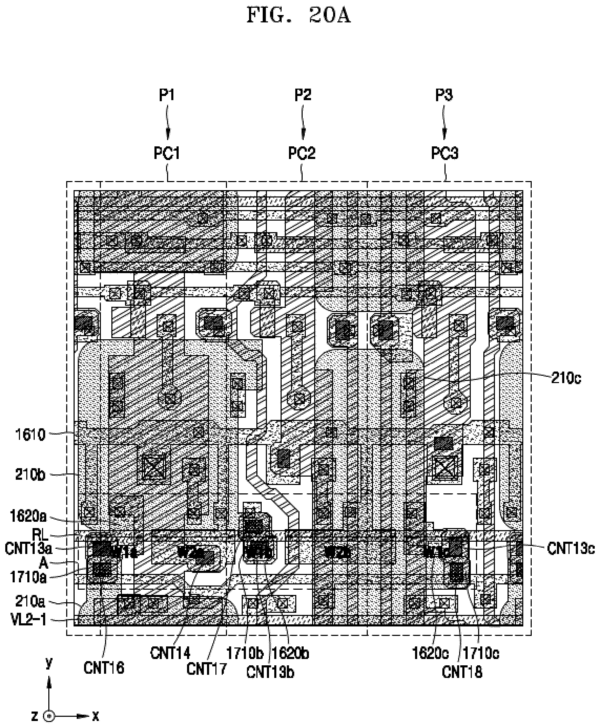

FIG. 17 shows a fourth conductive layer 1600 on the third conductive layer 1500. FIG. 18 shows a fifth conductive layer 1700 on the fourth conductive layer 1600. FIG. 19 shows a pixel electrode layer 2000 on the fifth conductive layer 1700. FIG. 20A is a configuration view of some layers of a display apparatus according to an embodiment. FIG. 20A shows the third conductive layer 1500, the fourth conductive layer 1600, the fifth conductive layer 1700, and the pixel electrode layer 2000 together.

Referring to FIG. 8 and FIGS. 17 to 20A, the fourth conductive layer 1600 may include a voltage transfer line 1610, a first pixel connection electrode 1620, a first connection electrode 1630, a second connection electrode 1640, a third connection electrode 1650, a fourth connection electrode 1660, a fifth connection electrode 1670, the first initialization voltage line VL1, the first initialization control line GIL, the scan line GWL, the compensation scan line GCL, and the bias voltage line VL3. For example, elements included in the fourth conductive layer 1600 may be disposed on a same layer. The fourth conductive layer 1600 may be denoted by a first source/drain layer or a first connection electrode layer.

The voltage transfer line 1610 may extend in the first direction (e.g., the x direction). The voltage transfer line 1610 may be electrically connected to each of the first pixel circuit PC1, the second pixel circuit PC2, and the third pixel circuit PC3 to transfer a voltage. A portion of the voltage transfer line 1610 may overlap the repair line RL in a plan view. Because a portion of the voltage transfer line 1610 overlaps the repair line RL, a parasitic capacitance may be formed in the overlapping region of the voltage transfer line 1610 and the repair line RL.

In an embodiment, the voltage transfer line 1610 may be electrically connected to a voltage line configured to transfer a direct current (DC) voltage (or a constant voltage). As an example, the voltage transfer line 1610 may be electrically connected to a voltage line configured to transfer the driving voltage ELVDD, the common voltage ELVSS, the first initialization voltage Vint, the second-1 initialization voltage Vaint1 or the second-2 initialization voltage Vaint2. An embodiment described with reference to FIGS. 8 and 20A shows, as an example, that the voltage transfer line 1610 may be electrically connected to the driving voltage line PL described below to receive the driving voltage ELVDD.

In an embodiment, the voltage transfer line 1610 may be disposed on a same layer as the first pixel connection electrode 1620. However, an embodiment is not limited thereto and the voltage transfer line 1610 and the first pixel connection electrode 1620 may be disposed on different layers in an embodiment.

The voltage transfer line 1610 may be electrically connected to the bottom conductive layer BML (see FIG. 9) through a first-1 contact hole CNT1a. The voltage transfer line 1610 may be electrically connected to the third conductive pattern 1310 (see FIG. 16) through a first-2 contact hole CNT1b. The voltage transfer line 1610 may be electrically connected to the first semiconductor pattern 1110 (see FIG. 10) through a first-3 contact hole CNT1c. The driving voltage ELVDD may be transferred to the storage capacitor Cst and the operation control transistor T5 by the voltage transfer line 1610.

The first pixel connection electrode 1620 may be apart from the voltage transfer line 1610. The first pixel connection electrode 1620 may be electrically insulated from the voltage transfer line 1610.

The first pixel connection electrode 1620 may be disposed for each pixel. As an example, the first pixel connection electrode 1620 may be disposed one by one in each of the first pixel P1, the second pixel P2, and the third pixel P3. As an example, the first-1 pixel connection electrode 1620a may be disposed in the first pixel P1, the first-2 pixel connection electrode 1620b may be disposed in the second pixel P2, and the first-3 pixel connection electrode 1620c may be disposed in the third pixel P3. Each of the first-1 pixel connection electrode 1620a, the first-2 pixel connection electrode 1620b, and the first-3 pixel connection electrode 1620c may be apart from the voltage transfer line 1610.

The first pixel connection electrode 1620 may be electrically connected to an organic light-emitting element of each pixel. As an example, the first-1 pixel connection electrode 1620a may be electrically connected to an organic light-emitting element of the first pixel P1, the first-2 pixel connection electrode 1620b may be electrically connected to an organic light-emitting element of the second pixel P2, and the first-3 pixel connection electrode 1620c may be electrically connected to an organic light-emitting element of the third pixel P3.

The first pixel connection electrode 1620 may be electrically connected to a pixel electrode of an organic light-emitting element of each pixel by a second pixel connection electrode 1710 described below. As an example, the first-1 pixel connection electrode 1620a may be electrically connected to the first pixel electrode 210a of the organic light-emitting element of the first pixel P1 by a second-1 pixel connection electrode 1710a, the first-2 pixel connection electrode 1620b may be electrically connected to the second pixel electrode 210b of the organic light-emitting element of the second pixel P2 by a second-2 pixel connection electrode 1710b, and the first-3 pixel connection electrode 1620c may be electrically connected to the third pixel electrode 210c of the organic light-emitting element of the third pixel P3 by a second-3 pixel connection electrode 1710c.

At least a portion of the first-1 pixel connection electrode 1620a may overlap the repair line RL, at least a portion of the first-2 pixel connection electrode 1620b may overlap the repair line RL, and at least a portion of the first-3 pixel connection electrode 1620c may overlap the repair line RL. Because each of the first-1 pixel connection electrode 1620a, the first-2 pixel connection electrode 1620b, and the first-3 pixel connection electrode 1620c overlaps the repair line RL in a plan view, a parasitic capacitance may be formed in the overlapping region of the first pixel connection electrode 1620 and the repair line RL.

The first pixel connection electrode 1620 may be electrically connected to the first semiconductor pattern 1110 through a second contact hole CNT2. As an example, the first-1 pixel connection electrode 1620a may be electrically connected to the first semiconductor pattern 1110 through the second contact hole CNT2. The first pixel connection electrode 1620 may electrically connect the first semiconductor pattern 1110 to an organic light-emitting element of each pixel.

Each of the first connection electrode 1630, the second connection electrode 1640, the third connection electrode 1650, the fourth connection electrode 1660, and the fifth connection electrode 1670 may have an isolated shape. Each of the first connection electrode 1630, the second connection electrode 1640, the third connection electrode 1650, the fourth connection electrode 1660, and the fifth connection electrode 1670 may be disposed for each pixel. As an example, each of the first connection electrode 1630, the second connection electrode 1640, the third connection electrode 1650, the fourth connection electrode 1660, and the fifth connection electrode 1670 may be disposed one by one in each of the first pixel P1, the second pixel P2, and the third pixel P3.

The first connection electrode 1630 may electrically connect the first conductive pattern 1210 to the third semiconductor pattern 1410. The first connection electrode 1630 may be electrically connected to the first conductive pattern 1210 through a third-1 contact hole CNT3a. The first connection electrode 1630 may be electrically connected to the third semiconductor pattern 1410 through a third-2 contact hole CNT3b. The first connection electrode 1630 may electrically connect the driving transistor T1 to the compensation transistor T3. The first connection electrode 1630 may electrically connect the storage capacitor Cst to the compensation transistor T3.

The second connection electrode 1640 may electrically connect the first semiconductor pattern 1110 to the third semiconductor pattern 1410. The second connection electrode 1640 may be electrically connected to the first semiconductor pattern 1110 through a fourth-1 contact hole CNT4a. The second connection electrode 1640 may be electrically connected to the third semiconductor pattern 1410 through a fourth-2 contact hole CNT4b. The second connection electrode 1640 may electrically connect the driving transistor T1 to the compensation transistor T3. The second connection electrode 1640 may electrically connect the emission control transistor T6 to the compensation transistor T3.

The third connection electrode 1650 may be electrically connected to the first semiconductor pattern 1110 (see FIG. 10) through a fifth contact hole CNT5. As an example, in the first pixel circuit PC1, the third connection electrode 1650 may be electrically connected to the first data line DL1 described below. For example, in the first pixel circuit PC1, the third connection electrode 1650 may be configured to transfer a data signal Dm applied by the first data line DL1 to the first semiconductor pattern 1110.

The fourth connection electrode 1660 may electrically connect the first semiconductor pattern 1110 to the second semiconductor pattern 1120. The fourth connection electrode 1660 may be electrically connected to the first semiconductor pattern 1110 through a sixth-1 contact hole CNT6a. The fourth connection electrode 1660 may be electrically connected to the second semiconductor pattern 1120 through a sixth-2 contact hole CNT6b. The fourth connection electrode 1660 may electrically connect the bias transistor T8 to the operation control transistor T5.

In the first pixel circuit PC1, the fifth connection electrode 1670 may electrically connect the first semiconductor pattern 1110 to the second-1 initialization voltage line VL2-1. In the second pixel circuit PC2 and the third pixel circuit PC3, the fifth connection electrode 1670 may electrically connect the first semiconductor pattern 1110 to the second-2 initialization voltage line VL2-2.

In the first pixel circuit PC1, the fifth connection electrode 1670 may be electrically connected to the first semiconductor pattern 1110 through a seventh-1 contact hole CNT7a and electrically connected to the second-1 initialization voltage line VL2-1 through a seventh-2 contact hole CNT7b. The second-1 initialization voltage Vaint1 may be transferred to the first semiconductor pattern 1110 of the first pixel P1 through the fifth connection electrode 1670. The fifth connection electrode 1670 may be configured to transfer the second-1 initialization voltage Vaint1 to the second initialization transistor T7 of the first pixel P1.

In each of the second pixel circuit PC2 and the third pixel circuit PC3, the fifth connection electrode 1670 may be electrically connected to the first semiconductor pattern 1110 through the seventh-1 contact hole CNT7a and electrically connected to the second-2 initialization voltage line VL2-2 through the seventh-2 contact hole CNT7b. In each of the second pixel P2 and the third pixel P3, the second-2 initialization voltage Vaint2 may be transferred to the first semiconductor pattern 1110 through the fifth connection electrode 1670. The fifth connection electrode 1670 may be configured to transfer the second-2 initialization voltage Vaint2 to the second initialization transistor T7 of the second pixel P2 and the third pixel P3.

Each of the first initialization control line GIL, the compensation scan line GCL, the bias voltage line VL3, the first initialization voltage line VL1 may extend in the first direction (e.g., the x direction).

The first initialization control line GIL may be configured to transfer a first initialization control signal GI. The first initialization control line GIL may electrically connect the fifth conductive pattern 1330 to the seventh conductive pattern 1520. The first initialization control line GIL may be electrically connected to the fifth conductive pattern 1330 through an eighth-1 contact hole CNT8a. The first initialization control line GIL may be electrically connected to the seventh conductive pattern 1520 through an eighth-2 contact hole CNT8b. For example, a first initialization control signal GI may be transferred to each of the fifth conductive pattern 1330 and the seventh conductive pattern 1520.

The scan line GWL may be configured to transfer a scan signal GW to each of the pixels. The scan line GWL may be electrically connected to the second conductive pattern 1220 by a ninth contact hole CNT9. For example, a scan signal GW may be transferred to the second conductive pattern 1220. The scan line GWL may be configured to transfer a scan signal GW to the gate electrode of the switching transistor T2.

The compensation scan line GCL may be configured to transfer a compensation scan signal GC to each of the pixels. The compensation scan line GCL may electrically connect the fourth conductive pattern 1320 to the sixth conductive pattern 1510. The compensation scan line GCL may be electrically connected to the fourth conductive pattern 1320 through a tenth-1 contact hole CNT10a. The compensation scan line GCL may be electrically connected to the sixth conductive pattern 1510 through a tenth-2 contact hole CNT10b. For example, a compensation scan signal GC may be transferred to each of the fourth conductive pattern 1320 and the sixth conductive pattern 1510.

The bias voltage Vobs may be applied to the bias voltage line VL3. The bias voltage line VL3 may be electrically connected to the second semiconductor pattern 1120 through an eleventh contact hole CNT11. For example, the bias voltage Vobs may be transferred to the second semiconductor pattern 1120.

The first initialization voltage Vint may be applied to the first initialization voltage line VL1. The first initialization voltage line VL1 may be electrically connected to the third semiconductor pattern 1410 through a twelfth contact hole CNT12. For example, the first initialization voltage Vint may be applied to the third semiconductor pattern 1410.

The fourth conductive layer 1600 may include metal, an alloy, a metal nitride, a conductive metal oxide, or the like. As an example, the fourth conductive layer 1600 may include silver (Ag), an alloy containing silver, molybdenum (Mo), an alloy containing molybdenum, aluminum (Al), an alloy containing aluminum, aluminum nitride (AlN), tungsten (W ), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO) or indium zinc oxide (IZO), the like, or a combination thereof. The fourth conductive layer 1600 may have a multi-layered structure.

The fifth conductive layer 1700 may be disposed on the fourth conductive layer 1600. The fifth conductive layer 1700 may include the second pixel connection electrode 1710, the driving voltage line PL, the first data line DL1, the second data line DL2, and the third data line DL3. For example, the second pixel connection electrode 1710, the driving voltage line PL, the first data line DL1, the second data line DL2, and the third data line DL3 may be disposed on a same layer. The fifth conductive layer 1700 may be denoted by a second source/drain layer or a second connection electrode layer.

The second pixel connection electrode 1710 may be disposed for each pixel. As an example, the second pixel connection electrode 1710 may be disposed one by one in each of the first pixel P1, the second pixel P2, and the third pixel P3. As an example, the second-1 pixel connection electrode 1710a may be disposed in the first pixel P1, the second-2 pixel connection electrode 1710b may be disposed in the second pixel P2, and the second-3 pixel connection electrode 1710c may be disposed in the third pixel P3.

The second pixel connection electrode 1710 may at least partially overlap the first pixel connection electrode 1620. At least a portion of the second-1 pixel connection electrode 1710a may overlap the first-1 pixel connection electrode 1620a. At least a portion of the second-2 pixel connection electrode 1710b may overlap the first-2 pixel connection electrode 1620b. At least a portion of the second-3 pixel connection electrode 1710c may overlap the first-3 pixel connection electrode 1620c.

The second pixel connection electrode 1710 may be electrically connected to an organic light-emitting element of each pixel. As an example, the second-1 pixel connection electrode 1710a may be electrically connected to an organic light-emitting element of the first pixel P1, the second-2 pixel connection electrode 1710b may be electrically connected to an organic light-emitting element of the second pixel P2, and the second-3 pixel connection electrode 1710c may be electrically connected to an organic light-emitting element of the third pixel P3.

The second pixel connection electrode 1710 may be electrically connected to the first pixel connection electrode 1620. As an example, the second-1 pixel connection electrode 1710a may be electrically connected to the first-1 pixel connection electrode 1620a through a thirteenth-1 contact hole CNT13a. As an example, the second-2 pixel connection electrode 1710b may be electrically connected to the first-2 pixel connection electrode 1620b through a thirteenth-2 contact hole CNT13b. As an example, the second-3 pixel connection electrode 1710c may be electrically connected to the first-3 pixel connection electrode 1620c through a thirteenth-3 contact hole CNT13c.

The second pixel connection electrode 1710 may electrically connect the first pixel connection electrode 1620 to a pixel electrode of an organic light-emitting element of each pixel. As an example, the second-1 pixel connection electrode 1710a may electrically connect the first-1 pixel connection electrode 1620a to the first pixel electrode 210a of the first pixel P1. As an example, the second-2 pixel connection electrode 1710b may electrically connect the first-2 pixel connection electrode 1620b to the second pixel electrode 210b of the second pixel P2. As an example, the second-3 pixel connection electrode 1710c may electrically connect the first-3 pixel connection electrode 1620c to the third pixel electrode 210c of the third pixel P3.

The driving voltage line PL may be configured to apply the driving voltage ELVDD to each of the pixels. The driving voltage line PL may extend in the second direction (e.g., the y direction). The driving voltage line PL may be electrically connected to the voltage transfer line 1610 through a fourteenth contact hole CNT14.

The first data line DL1, the second data line DL2, and the third data line DL3 may be respectively electrically connected to the first pixel circuit PC1, the second pixel circuit PC2, and the third pixel circuit PC3. The first to third data lines DL1, DL2, and DL3 may be configured to respectively transfer data signals Dm to the first to third pixels P1, P2, and P3. Each of the first data line DL1, the second data line DL2, and the third data line DL3 may extend in the second direction (e.g., the y direction).

In the first pixel circuit PC1, the first data line DL1 may be electrically connected to the third connection electrode 1650 through a fifteenth contact hole CNT15. Likewise, in the second pixel circuit PC2, the second data line DL2 may be electrically connected to the third connection electrode 1650 of the second pixel circuit PC2, and in the third pixel circuit PC3, the third data line DL3 may be electrically connected to the third connection electrode 1650 of the third pixel circuit PC3. Because the third connection electrode 1650 may be electrically connected to the first semiconductor pattern 1110 (see FIG. 10), a data signal Dm applied to the first data line DL1 may be transferred to the first semiconductor pattern 1110. The third connection electrode 1650 may be configured to transfer a data signal Dm to the switching transistor T2.

The fifth conductive layer 1700 may include metal, an alloy, a metal nitride, a conductive metal oxide, or the like. As an example, the fifth conductive layer 1700 may include silver (Ag), an alloy containing silver, molybdenum (Mo), an alloy containing molybdenum, aluminum (Al), an alloy containing aluminum, aluminum nitride (AlN), tungsten (W ), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO) or indium zinc oxide (IZO), the like, or a combination thereof. The fifth conductive layer 1700 may have a multi-layered structure.

The pixel electrode layer 2000 may be disposed on the fifth conductive layer 1700. The pixel electrode layer 2000 may include the first pixel electrode 210a of the organic light-emitting element of the first pixel P1, the second pixel electrode 210b of the organic light-emitting element of the second pixel P2, and the third pixel electrode 210c of the organic light-emitting element of the third pixel P3.

The first pixel electrode 210a, the second pixel electrode 210b, and the third pixel electrode 210c may be apart from each other. Each of the first pixel electrode 210a, the second pixel electrode 210b, and the third pixel electrode 210c may be a (semi) light-transmissive electrode or reflective electrode. As an example, each of the first pixel electrode 210a, the second pixel electrode 210b, and the third pixel electrode 210c may include a reflective layer and a transparent or semitransparent electrode layer on the reflective layer, wherein the reflective layer may include Ag, Mg, Al, Pt, Pd, Au, Ni, Nd, Ir, Cr, a compound thereof, or a combination thereof. The transparent or semitransparent electrode layer may include at least one of indium tin oxide (ITO), indium zinc oxide (IZO), zinc oxide (ZnO), indium oxide (In₂O₃), indium gallium oxide (IGO), aluminum zinc oxide (AZO) , or a combination thereof. As an example, each of the first pixel electrode 210a, the second pixel electrode 210b, and the third pixel electrode 210c may have a three-layered structure of ITO/Ag/ITO.

The first pixel electrode 210a may be electrically connected to the second-1 pixel connection electrode 1710a through a sixteenth contact hole CNT16. The second pixel electrode 210b may be electrically connected to the second-2 pixel connection electrode 1710b through a seventeenth contact hole CNT17. The third pixel electrode 210c may be electrically connected to the second-3 pixel connection electrode 1710c through an eighteenth contact hole CNT18.

The first to third pixel electrodes 210a, 210b, and 210c of each pixel may be electrically connected to the first semiconductor pattern 1110 (see FIG. 10) by the first pixel connection electrode 1620 and the second pixel connection electrode 1710. As an example, the first pixel electrode 210a may be electrically connected to the first semiconductor pattern 1110 by the first-1 pixel connection electrode 1620a and the second-1 pixel connection electrode 1710a. The first pixel connection electrode 1620 and the second pixel connection electrode 1710 may electrically connect the organic light-emitting element to the second initialization transistor T7 of each pixel.

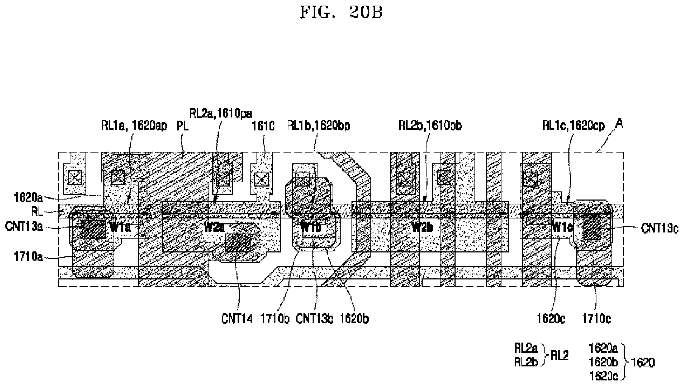

FIG. 20B is an enlarged view of a region 'A' of FIG. 20A. For convenience of illustration, FIG. 20B omits the first to third pixel electrodes 210a, 210b, and 210c shown in FIG. 20A.

Referring to FIGS. 20A and 20B, the repair line RL may include portions respectively overlapping the first-1 pixel connection electrode 1620a, the first-2 pixel connection electrode 1620b, and the first-3 pixel connection electrode 1620c, and a portion overlapping the voltage transfer line 1610.

As an example, the repair line RL may include a first-1 portion RL1a overlapping the first-1 pixel connection electrode 1620a, a first-2 portion RL1b overlapping the first-2 pixel connection electrode 1620b, and a first-3 portion RL1c overlapping the first-3 pixel connection electrode 1620c. In the case where the first pixel P1 may be a defective pixel, the first-1 portion RL1a of the repair line RL may be a portion to which a laser beam may be irradiated during the repair process. In the case where the second pixel P2 is a defective pixel, the first-2 portion RL1b of the repair line RL may be a portion to which a laser beam may be irradiated during the repair process. In the case where the third pixel P3 may be a defective pixel, the first-3 portion RL1c of the repair line RL may be a portion to which a laser beam may be irradiated during the repair process.

As an example, the repair line RL may include a second portion RL2 overlapping the voltage transfer line 1610. In an embodiment, the second portion RL2 of the repair line RL overlapping the voltage transfer line 1610 may include a second-1 portion RL2a disposed between the first-1 portion RL1a and the first-2 portion RL1b, and a second-2 portion RL2b disposed between the first-2 portion RL1b and the first-3 portion RL1c.

The first-1 pixel connection electrode 1620a may include a portion 1620ap overlapping the repair line RL. The first-2 pixel connection electrode 1620b may include a portion 1620bp overlapping the repair line RL. The first-3 pixel connection electrode 1620c may include a portion 1620cp overlapping the repair line RL.

The voltage transfer line 1610 may include a first portion 1610pa and a second portion 1610pb overlapping the repair line RL. The first portion 1610pa of the voltage transfer line 1610 may be disposed between the portion 1620ap of the first-1 pixel connection electrode 1620a overlapping the repair line RL, and the portion 1620bp of the first-2 pixel connection electrode 1620b overlapping the repair line RL. The second portion 1610pb of the voltage transfer line 1610 may be disposed between the portion 1620bp of the first-2 pixel connection electrode 1620b overlapping the repair line RL, and the portion 1620cp of the first-3 pixel connection electrode 1620c overlapping the repair line RL.

The area (the size) of the first portion 1610pa of the voltage transfer line 1610 may be greater than the area (the size) of the portion 1620ap of the first-1 pixel connection electrode 1620a overlapping the repair line RL. The area (the size) of the first portion 1610pa of the voltage transfer line 1610 may be greater than the area (the size) of the portion 1620bp of the first-2 pixel connection electrode 1620b overlapping the repair line RL. The area (the size) of the first portion 1610pa of the voltage transfer line 1610 may be greater than the area (the size) of the portion 1620cp of the first-3 pixel connection electrode 1620c overlapping the repair line RL.

The area (the size) of the second portion 1610pb of the voltage transfer line 1610 may be greater than the area (the size) of the portion 1620ap of the first-1 pixel connection electrode 1620a overlapping the repair line RL. The area (the size) of the second portion 1610pb of the voltage transfer line 1610 may be greater than the area (the size) of the portion 1620bp of the first-2 pixel connection electrode 1620b overlapping the repair line RL. The area (the size) of the second portion 1610pb of the voltage transfer line 1610 may be greater than the area (the size) of the portion 1620cp of the first-3 pixel connection electrode 1620c overlapping the repair line RL.

A width W2a in the first direction (e.g., the x direction) of the first portion 1610pa of the voltage transfer line 1610 may be greater than a width W1a in the first direction (e.g., the x direction) of the portion 1620ap of the first-1 pixel connection electrode 1620a overlapping the repair line RL. In other words, the width W2a in the first direction (e.g., the x direction) of the second-1 portion RL2a of the repair line RL may be greater than the width W1a in the first direction (e.g., the x direction) of the first-1 portion RL1a.

A width W2a in the first direction (e.g., the x direction) of the first portion 1610pa of the voltage transfer line 1610 may be greater than a width W1b in the first direction (e.g., the x direction) of the portion 1620bp of the first-2 pixel connection electrode 1620b overlapping the repair line RL. In other words, the width W2a in the first direction (e.g., the x direction) of the second-1 portion RL2a of the repair line RL may be greater than the width W1b in the first direction (e.g., the x direction) of the first-2 portion RL1b.

A width W2a in the first direction (e.g., the x direction) of the first portion 1610pa of the voltage transfer line 1610 may be greater than a width W1c in the first direction (e.g., the x direction) of the portion 1620cp of the first-3 pixel connection electrode 1620c overlapping the repair line RL. In other words, the width W2a in the first direction (e.g., the x direction) of the second-1 portion RL2a of the repair line RL may be greater than the width W1c in the first direction (e.g., the x direction) of the first-3 portion RL1c.

A width W2b in the first direction (e.g., the x direction) of the second portion 1610pb of the voltage transfer line 1610 may be greater than a width W1a in the first direction (e.g., the x direction) of the portion 1620ap of the first-1 pixel connection electrode 1620a overlapping the repair line RL. In other words, the width W2b in the first direction (e.g., the x direction) of the second-2 portion RL2b of the repair line RL may be greater than the width W1a in the first direction (e.g., the x direction) of the first-1 portion RL1a.

A width W2b in the first direction (e.g., the x direction) of the second portion 1610pb of the voltage transfer line 1610 may be greater than a width W1b in the first direction (e.g., the x direction) of the portion 1620bp of the first-2 pixel connection electrode 1620b overlapping the repair line RL. In other words, the width W2b in the first direction (e.g., the x direction) of the second-2 portion RL2b of the repair line RL may be greater than the width W1b in the first direction (e.g., the x direction) of the portion 1620bp of the first-2 pixel connection electrode 1620b overlapping the repair line RL.

The width W2b in the first direction (e.g., the x direction) of the second portion 1610pb of the voltage transfer line 1610 may be greater than the width W1c in the first direction (e.g., the x direction) of the portion 1620cp of the first-3 pixel connection electrode 1620c overlapping the repair line RL. In other words, the width W2b in the first direction (e.g., the x direction) of the second-2 portion RL2b of the repair line RL may be greater than the width W1c in the first direction (e.g., the x direction) of the portion 1620cp of the first-3 pixel connection electrode 1620c overlapping the repair line RL.

In the display apparatus 1 according to an embodiment, the voltage transfer line 1610 may be formed to overlap the repair line RL with an area larger than the area of the overlapping region of the first pixel connection electrode 1620 and the repair line RL. Accordingly, the influence of a parasitic capacitor formed by overlapping of the first pixel connection electrode 1620 and the repair line RL on adjacent pixels may be reduced. Specifically, coupling between parasitic capacitors formed in the overlapping region of the first pixel connection electrode 1620 and the repair line RL of a defective pixel and a pixel adjacent to the defective pixel may be reduced. Accordingly, because brightness difference of the display apparatus 1 may be reduced, the display quality of the display apparatus 1 may be improved. Particularly, in the case where an organic light-emitting element included in each pixel has a tandem structure in which two light-emitting parts may be connected in series, the influence of coupling between parasitic capacitors formed in the overlapping region of the first pixel connection electrode 1620 and the repair line RL of a defective pixel and a pixel adjacent to the defective pixel may be remarkably reduced.

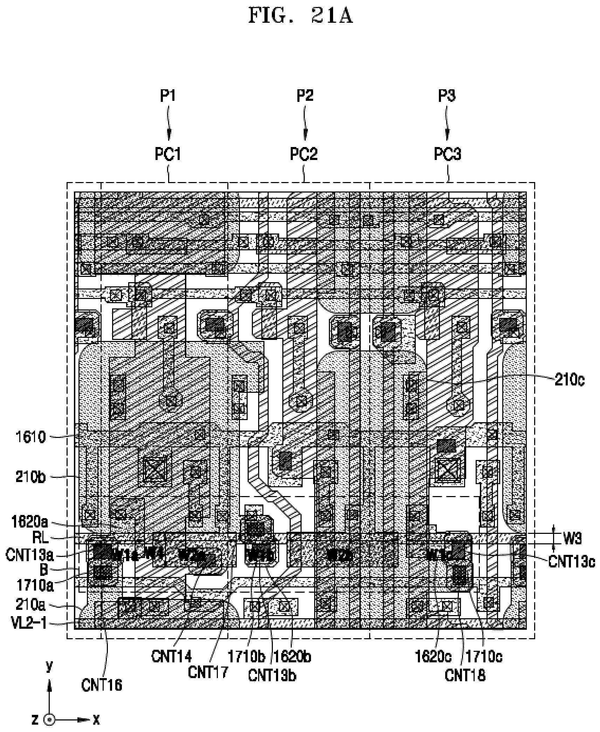

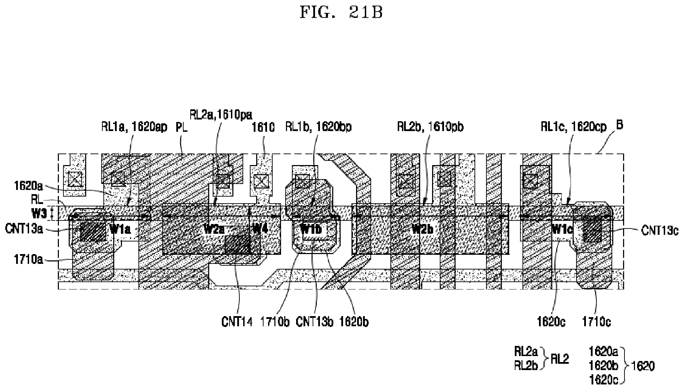

FIG. 21A is a configuration view of some layers of a display apparatus according to an embodiment. FIG. 21A shows a modified embodiment of the embodiment described with reference to FIGS. 8 to 20B. Similar to FIG. 20A, FIG. 21A shows the third conductive layer 1500, the fourth conductive layer 1600, the fifth conductive layer 1700, and the pixel electrode layer 2000 together. In FIG. 21A, for convenience of description, the bottom conductive layer BML, the first semiconductor layer 1100, the first conductive layer 1200, the second conductive layer 1300, and the second semiconductor layer 1400 are omitted and may be the same as those described with reference to FIGS. 9 to 14. FIG. 21B is an enlarged view of a region 'B' of FIG. 21A.

Because FIGS. 21A and 21B show the modified embodiment of the embodiment described with reference to FIGS. 20A and 20B, repeated descriptions are omitted and differences are described.

Referring to FIGS. 21A and 21B, the repair line RL may include portions having different widths in the second direction (e.g., the y direction). As an example, the width in the second direction (e.g., the y direction) of a portion of the repair line RL overlapping the voltage transfer line 1610 may be greater than the width in the second direction (e.g., the y direction) of each of portions of the repair line RL respectively overlapping the first-1 pixel connection electrode 1620a, the first-2 pixel connection electrode 1620b, and the first-3 pixel connection electrode 1620c.

As an example, a width W4 in the second direction (e.g., the y direction) of the second-1 portion RL2a of the repair line RL may be greater than a width W3 in the second direction (e.g., the y direction) of the first-1 portion RL1a. As an example, the width W4 in the second direction (e.g., the y direction) of the second-1 portion RL2a of the repair line RL may be greater than the width W3 in the second direction (e.g., the y direction) of the first-2 portion RL1b of the repair line RL. As an example, the width W4 in the second direction (e.g., the y direction) of the second-1 portion RL2a of the repair line RL may be greater than the width W3 in the second direction (e.g., the y direction) of the first-3 portion RL1c of the repair line RL. Likewise, the width in the second direction (e.g., the y direction) of the second-2 portion RL2b of the repair line RL may be greater than the width W3 in the second direction (e.g., the y direction) of the first-1 portion RL1a, the first-2 portion RL1b, and/or the first-3 portion RL1c.

The 'width' of an element described in the specification may be defined as a maximum width or average width of the element. In an embodiment, although it is shown that the widths in the second direction of the first-1 portion RL1a, the first-2 portion RL1b, and the first-3 portion RL1c of the repair line RL may be equal to each other, the embodiment is not limited thereto. Although it is shown that the widths in the second direction of the second-1 portion RL2a and the second-2 portion RL2b of the repair line RL may be equal to each other, the embodiment is not limited thereto. However, even in the case where the widths in the second direction of the first-1 portion RL1a, the first-2 portion RL1b, and the first-3 portion RL1c of the repair line RL may be different from each other, and the widths in the second direction of the second-1 portion RL2a and the second-2 portion RL2b may be different from each other, the widths in the second direction of the second-1 portion RL2a and the second-2 portion RL2b may be greater than the widths in the second direction of the first-1 portion RL1a, the first-2 portion RL1b, and the first-3 portion RL1c.

The width W4 in the second direction (e.g., the y direction) of the first portion 1610pa of the voltage transfer line 1610 may be greater than the width W3 in the second direction (e.g., the y direction) of the portion 1620ap of the first-1 pixel connection electrode 1620a overlapping the repair line RL. The width W4 in the second direction (e.g., the y direction) of the first portion 1610pa of the voltage transfer line 1610 may be greater than the width W3 in the second direction (e.g., the y direction) of the portion 1620bp of the first-2 pixel connection electrode 1620b overlapping the repair line RL. The width W4 in the second direction (e.g., the y direction) of the first portion 1610pa of the voltage transfer line 1610 may be greater than the width W3 in the second direction (e.g., the y direction) of the portion 1620cp of the first-3 pixel connection electrode 1620c overlapping the repair line RL. Likewise, the width in the second direction (e.g., the y direction) of the second portion 1610pb of the voltage transfer line 1610 may be greater than the width in the second direction of the portion 1620ap of the first-1 pixel connection electrode 1620a overlapping the repair line RL, the width in the second direction of the portion 1620bp of the first-2 pixel connection electrode 1620b overlapping the repair line RL, and/or the width in the second direction of the portion 1620cp of the first-3 pixel connection electrode 1620c overlapping the repair line RL.

FIG. 22 is a schematic cross-sectional view of the display part 10 of the display apparatus 1 according to an embodiment. FIG. 22 schematically shows a portion of a cross-section corresponding to the first pixel P1 in the display part 10 of the display apparatus 1 according to an embodiment described with reference to FIG. 20B.

Referring to FIG. 22, the display apparatus 1 may include the substrate 100, at least one thin-film transistors TFT1 and TFT2, the repair line RL, and the first organic light-emitting element OLED1, and an encapsulation member 300 disposed over the substrate 100.

The substrate 100 may include glass, metal, or polymer resin. In an embodiment, the substrate 100 may be flexible or bendable. The substrate 100 may include polymer resin such as polyethersulphone, polyacrylate, polyetherimide, polyethylene naphthalate, polyethylene terephthalate, polyphenylene sulfide, polyarylate, polyimide, polycarbonate, cellulose acetate propionate, or a combination thereof. The substrate 100 may have a multi-layered structure including two layers each including the polymer resin, and a barrier layer including an inorganic material (such as silicon oxide, silicon nitride, and silicon oxynitride) therebetween. However, various modifications may be made.

The bottom conductive layer BML may be disposed on the substrate 100.

The display apparatus 1 may include a buffer layer 102 disposed on the bottom conductive layer BML. The buffer layer 102 may be configured to prevent metal atoms or impurities and the like from the substrate 100 from diffusing to the first semiconductor layer 1100 (see FIG. 10) disposed thereon. The buffer layer 102 may include an insulating material. As an example, the buffer layer 102 may include an inorganic insulating material such as silicon oxide, silicon nitride, silicon oxynitride, aluminum oxide, or a combination thereof.

The first thin-film transistor TFT1 may be disposed on the buffer layer 102. The first thin-film transistor TFT1 may include a first active layer Act1, a first gate electrode GE1, a first source electrode SE1, and a first drain electrode DE1. The first thin-film transistor TFT1 may be electrically connected to the first organic light-emitting element OLED1. In an embodiment, the first thin-film transistor TFT1 may be the emission control transistor T6 (see FIG. 5).

The first semiconductor layer 1100 (see FIG. 10) may be disposed on the buffer layer 102. The first active layer Act1 of the first thin-film transistor TFT1 may be disposed on the buffer layer 102.

In an embodiment, the first active layer Act1 of the first thin-film transistor TFT1 may correspond to the first semiconductor pattern 1110 of the first semiconductor layer 1100. The first active layer Act1 of the first thin-film transistor TFT1 may include a silicon semiconductor material. As an example, the first active layer Act1 may include amorphous silicon or polycrystalline silicon. As an example, the first active layer Act1 may include polycrystalline silicon crystallized at low temperature. The first active layer Act1 may include a channel region, a drain region, and a source region, wherein the channel region overlaps the first gate electrode GE1, and the drain region and the source region may be on two opposite sides of the channel region.

The display apparatus 1 may include a first gate insulating layer 103 disposed on the first semiconductor layer 1100 (see FIG. 10). The first gate insulating layer 103 may cover the first semiconductor layer 1100 (see FIG. 10) and be disposed on the buffer layer 102. The first gate insulating layer 103 may include an insulating material. As an example, the first gate insulating layer 103 may include an inorganic insulating material such as silicon oxide, silicon nitride, silicon oxynitride, aluminum oxide, or a combination thereof.

The first conductive layer 1200 (see FIG. 11) may be disposed on the first gate insulating layer 103. The first gate electrode GE1 of the first thin-film transistor TFT1 may be disposed on the first gate insulating layer 103. In an embodiment, the first gate electrode GE1 of the first thin-film transistor TFT1 may correspond to a portion of the emission control line EML of the first conductive layer 1200.

The display apparatus 1 may include a second gate insulating layer 104 disposed on the first conductive layer 1200 (see FIG. 11). The second gate insulating layer 104 may cover the first conductive layer 1200 (see FIG. 11) and be disposed on the first gate insulating layer 103. The second gate insulating layer 104 may include an insulating material. As an example, the second gate insulating layer 104 may include an inorganic insulating material such as silicon oxide, silicon nitride, silicon oxynitride, aluminum oxide, or a combination thereof.

The second thin-film transistor TFT2 may be disposed on the second gate insulating layer 104. The second thin-film transistor TFT2 may include a second active layer Act2, a second gate electrode GE2, a second source electrode SE2, and a second drain electrode DE2. In an embodiment, the second thin-film transistor TFT2 may be the compensation transistor T3 (see FIG. 5) or the first initialization transistor T4 (see FIG. 5).

The second conductive layer 1300 (see FIG. 13) may be disposed on the second gate insulating layer 104. FIG. 22 shows, as an example, the fourth conductive pattern 1320 of the second conductive layer 1300, and the fourth conductive pattern 1320 may be a lower gate electrode of the second thin-film transistor TFT2. The fourth conductive pattern 1320 may be disposed on the second gate insulating layer 104.

The display apparatus 1 may include a first interlayer insulating layer 105 disposed on the second conductive layer 1300 (see FIG. 13). The first interlayer insulating layer 105 may cover the second conductive layer 1300 (see FIG. 13) and be disposed on the second gate insulating layer 104. The first interlayer insulating layer 105 may include an insulating material. As an example, the first interlayer insulating layer 105 may include an inorganic insulating material such as silicon oxide, silicon nitride, silicon oxynitride, aluminum oxide, or a combination thereof.

The second semiconductor layer 1400 (see FIG. 14) may be disposed on the first interlayer insulating layer 105. The second active layer Act2 of the second thin-film transistor TFT2 may be disposed on the first interlayer insulating layer 105.

In an embodiment, the second active layer Act2 of the second thin-film transistor TFT2 may correspond to the third semiconductor pattern 1410 of the second semiconductor layer 1400. The second active layer Act2 of the second thin-film transistor TFT2 may include an oxide semiconductor material. As an example, the second active layer Act2 may include an oxide of at least one of indium (In), gallium (Ga), tin (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn).

The display apparatus 1 may include a third gate insulating layer 106 disposed on the second semiconductor layer 1400 (see FIG. 14). The third gate insulating layer 106 may cover the second semiconductor layer 1400 (see FIG. 14) and be disposed on the first interlayer insulating layer 105. The third gate insulating layer 106 may include an insulating material. As an example, the third gate insulating layer 106 may include an inorganic insulating material such as silicon oxide, silicon nitride, silicon oxynitride, aluminum oxide, or a combination thereof.

The third conductive layer 1500 (see FIG. 15) may be disposed on the third gate insulating layer 106. The second gate electrode GE2 of the second thin-film transistor TFT2 may be disposed on the third gate insulating layer 106. In an embodiment, the second gate electrode GE2 of the second thin-film transistor TFT2 may correspond to the sixth conductive pattern 1510 of the third conductive layer 1500. Because the third conductive layer 1500 (see FIG. 15) includes the repair line RL, the repair line RL and the second gate electrode GE2 of the second thin-film transistor TFT2 may be disposed on a same layer.

The display apparatus 1 may include a second interlayer insulating layer 107 disposed on the third conductive layer 1500 (see FIG. 15). The second interlayer insulating layer 107 may cover the third conductive layer 1500 (see FIG. 15) and be disposed on the third gate insulating layer 106. The second interlayer insulating layer 107 may include an insulating material. As an example, the second interlayer insulating layer 107 may include an inorganic insulating material such as silicon oxide, silicon nitride, silicon oxynitride, aluminum oxide, or a combination thereof.

In FIG. 22, for convenience of illustration, the upper surface of each of the buffer layer 102, the first gate insulating layer 103, the second gate insulating layer 104, the first interlayer insulating layer 105, the third gate insulating layer 106, and the second interlayer insulating layer 107 may be shown to be substantially flat, the disclosure is not limited thereto. As an example, the buffer layer 102, the first gate insulating layer 103, the second gate insulating layer 104, the first interlayer insulating layer 105, the third gate insulating layer 106, and the second interlayer insulating layer 107 may be inorganic insulating layers including an inorganic material, these layers may be disposed with a substantially uniform thickness along the profile of the element.

The fourth conductive layer 1600 (see FIG. 17) may be disposed on the second interlayer insulating layer 107. The first source electrode SE1 and the first drain electrode DE1 of the first thin-film transistor TFT1 may be disposed on the second interlayer insulating layer 107. In an embodiment, the first drain electrode DE1 of the first thin-film transistor TFT1 may correspond to the first-1 pixel connection electrode 1620a. The second source electrode SE2 and the second drain electrode DE2 of the second thin-film transistor TFT2 may be disposed on the second interlayer insulating layer 107. Because the fourth conductive layer 1600 (see FIG. 17) includes the voltage transfer line 1610, the voltage transfer line 1610, the first source/drain electrodes SE1 and DE1 of the first thin-film transistor TFT1, the second source/drain electrodes SE2 and DE2 of the second thin-film transistor TFT2, and the first-1 pixel connection electrode 1620a may be disposed on a same layer.

As shown in FIG. 22, the repair line RL may overlap the first-1 pixel connection electrode 1620a to form a first parasitic capacitor and overlap the voltage transfer line 1610 to form a second parasitic capacitor. To overlap the repair line RL and form a relatively large second parasitic capacitor, the voltage transfer line 1610 may be disposed on a layer closest to the repair line RL. As an example, another conductive layer may not be disposed between the repair line RL and the voltage transfer line 1610 in a z direction. As an example, as described with reference to FIG. 22, in the case where the repair line RL may be formed on the third conductive layer 1500, the voltage transfer line 1610 may be formed in the fourth conductive layer 1600 which may be a conductive layer closest to the third conductive layer 1500.

The display apparatus 1 may include a first planarization layer 108 disposed on the fourth conductive layer 1600 (see FIG. 17). The first planarization layer 108 may cover the fourth conductive layer 1600 (see FIG. 17) and be disposed on the second interlayer insulating layer 107. The first planarization layer 108 may provide a substantially flat upper surface on the fourth conductive layer 1600 (see FIG. 17). The first planarization layer 108 may include an organic insulating material. As an example, the first planarization layer 108 may include benzocyclobutene (BCB), polyimide, hexamethyldisiloxane (HMDSO), polymethylmethacrylate (PMMA), polystyrene, polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a combination thereof.

The fifth conductive layer 1700 (see FIG. 18) may be disposed on the first planarization layer 108.

FIG. 22 shows, as an example, the second-1 pixel connection electrode 1710a included in the fifth conductive layer 1700 and the driving voltage line PL. The second-1 pixel connection electrode 1710a and the driving voltage line PL may be disposed on the first planarization layer 108. The second-1 pixel connection electrode 1710a may be electrically connected to the first-1 pixel connection electrode 1620a to electrically connect the first thin-film transistor TFT1 to the first organic light-emitting element OLED1. In an embodiment, the driving voltage line PL may be electrically connected to the voltage transfer line 1610 to transfer the driving voltage ELVDD to the voltage transfer line 1610.

The display apparatus 1 may include a second planarization layer 109 disposed on the fifth conductive layer 1700 (see FIG. 18). The second planarization layer 109 may cover the fifth conductive layer 1700 (see FIG. 18) and be disposed on the first planarization layer 108. The second planarization layer 109 may provide a substantially flat upper surface on the fifth conductive layer 1700 (see FIG. 18). The second planarization layer 109 may include an organic insulating material. As an example, the second planarization layer 109 may include benzocyclobutene (BCB), polyimide, hexamethyldisiloxane (HMDSO), polymethylmethacrylate (PMMA), polystyrene, polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a combination thereof.

The first organic light-emitting element OLED1 may be disposed on the second planarization layer 109. The first organic light-emitting element OLED1 may include the first pixel electrode 210a, an intermediate layer 220, and an opposite electrode 230, wherein the intermediate layer 220 includes an emission layer.

A pixel-defining layer 110 may be disposed on the second planarization layer 109. The pixel-defining layer 110 may prevent arcs and the like from occurring at the edges of the first pixel electrode 210a by increasing a distance between the edges of the first pixel electrode 210a and the opposite electrode 230 over the first pixel electrode 210a. The pixel-defining layer 110 may include an organic insulating material such as polyimide, an acrylic resin, benzocyclobutene, a phenolic resin, the like, or a combination thereof, and be formed by using spin coating and the like.

At least a portion of the intermediate layer 220 of the first organic light-emitting element OLED1 may be disposed in a pixel opening 110OP formed by the pixel-defining layer 110.

The intermediate layer 220 may include the emission layer. The emission layer may include an organic material including a fluorescent or phosphorous material configured to emit red, green, blue, or white light. The emission layer may include a polymer organic material or a low molecular weight organic material. Functional layers may be selectively further disposed under and on the emission layer, the functional layers including a hole transport layer (HTL), a hole injection layer (HIL), an electron transport layer (ETL), and an electron injection layer (EIL).

The emission layer may have a shape patterned to correspond to the first pixel electrode 210a. As an example, layers other than the emission layer included in the intermediate layer 220 provided over the first to third pixel electrodes 210a, 210b, and 210c may be integral with each other. However, various modifications may be made.

The opposite electrode 230 may be a light-transmissive electrode or a reflective electrode. As an example, the opposite electrode 230 may be a transparent or semi-transparent electrode and may include a metal thin film including Li, Ca, LiF, Al, Ag, Mg, or compound thereof and having a small work function. The opposite electrode 230 may further include a transparent conductive oxide (TCO) layer such as ITO, indium zinc oxide (IZO), ZnO, In₂O₃, or a combination thereof disposed on the metal thin film. The opposite electrode 230 may be integrally formed over the entire surface of the active area AA (see FIG. 1) and disposed on the intermediate layer 220 and the pixel-defining layer 110.

The encapsulation member 300 may be disposed on the first organic light-emitting element OLED1 to encapsulate the first organic light-emitting element OLED1. The encapsulation member 300 may include at least one inorganic layer and at least one organic layer. As an example, the encapsulation member 300 may include a first inorganic encapsulation layer 310, an organic encapsulation layer 320, and a second inorganic encapsulation layer 330 that may be sequentially stacked on each other.

The first inorganic encapsulation layer 310 and the second inorganic encapsulation layer 330 may include an inorganic insulating material such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), zinc oxide (ZnOₓ, may be ZnO or ZnO₂), or a combination thereof. The first inorganic encapsulation layer 310 and the second inorganic encapsulation layer 330 may each have a single-layered structure or a multi-layered structure including the inorganic insulating material.

The organic encapsulation layer 320 may alleviate internal stress of the first inorganic encapsulation layer 310 and/or the second inorganic encapsulation layer 330. The organic encapsulation layer 320 may include a polymer-based material. The polymer-based material may include polyethylene terephthalate, polyethylene naphthalate, polycarbonate, polyimide, polyethylene sulfonate, polyoxymethylene, polyarylate, hexamethyldisiloxane, an acryl-based resin (e.g., polymethylmethacrylate, poly acrylic acid, and the like), or an arbitrary combination thereof.

The organic encapsulation layer 320 has flowability and may be formed by applying a material containing monomers and then reacting the monomers to combine to form a polymer using heat or light such as ultraviolet rays. For example, the organic encapsulation layer 320 may be formed by coating a polymer material.

The display apparatus 1 may further include a color filter layer. The color filter layer may include a first color filter, a second color filter, and a third color filter to respectively correspond to the first pixel P1, the second pixel P2, and the third pixel P3. As an example, in FIG. 22, the first color filter may be disposed to correspond to an emission area of the first organic light-emitting element OLED1. In an embodiment, the first color filter may be a red color filter, the second color filter may be a green color filter, and the third color filter may be a blue color filter.

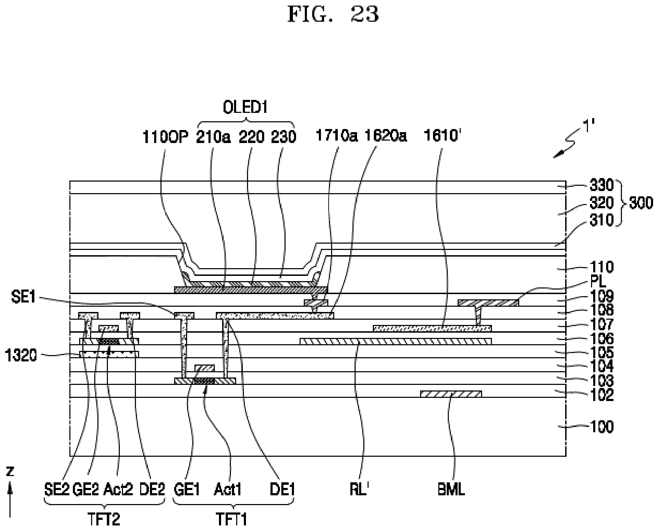

FIG. 23 is a schematic cross-sectional view of a display part of the display apparatus 1' according to an embodiment. FIG. 23 is a modified embodiment of FIG. 22, repeated descriptions are omitted, and differences are described.

Referring to FIG. 23, the first-1 pixel connection electrode 1620a and a voltage transfer line 1610' may be disposed on different layers.

In an embodiment, a repair line RL' may be formed in a conductive layer not adjacent to the first-1 pixel connection electrode 1620a in order to reduce the size of a parasitic capacitor with the first-1 pixel connection electrode 1620a. As an example, the repair line RL' may be formed on the second semiconductor layer 1400 (see FIG. 14). As an example, the repair line RL' and the second active layer Act2 of the second thin-film transistor TFT2 may be disposed on a same layer. However, this is just an example and is not limited thereto. The configuration of the repair line RL' may be changed variously, such as being formed on the second conductive layer 1300 (see FIG. 13).

To overlap the repair line RL' and form a relatively large parasitic capacitor, the voltage transfer line 1610' may be disposed on a layer closest to the repair line RL'. As an example, as shown in FIG. 23, in the case where the repair line RL' may be formed on the second semiconductor layer 1400 (see FIG. 14), the voltage transfer line 1610 may be formed on the third conductive layer 1500 which may be a conductive layer closest to the second semiconductor layer 1400 (see FIG. 14). For example, the voltage transfer line 1610' may be disposed on the third gate insulating layer 106. The voltage transfer line 1610' and the second gate electrode GE2 of the second thin-film transistor TFT2 may be disposed on a same layer. However, this is just an example and the position of the voltage transfer line 1610' may be variously changed depending on the configuration of the repair line RL'.

The display apparatus according to the embodiment may be applied to various electronic apparatuses. An electronic apparatus according to an embodiment of the present disclosure may include the display apparatus(e.g., the display apparatus of FIG. 1) described above, and may further include modules or apparatuses having additional functions in addition to the display apparatus.

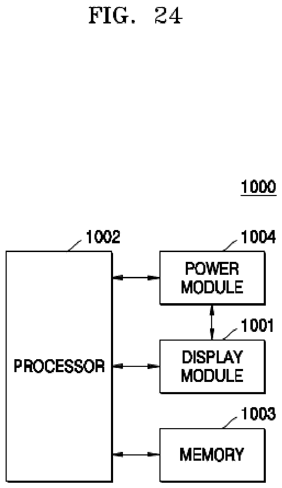

FIG. 24 is a block diagram of an electronic apparatus according to an embodiment.

Referring to FIG. 24, an electronic apparatus 1000 according to an embodiment may include a display module 1001, a processor 1002, a memory 1003, and a power module 1004.

The processor 1002 may include at least one of a central processing unit (CPU), an application processor (AP), a graphic processing unit (GPU), a communication processor (CP), an image signal processor (ISP), and a controller.

The memory 1003 may store data information necessary for the operation of the processor 1002 or the display module 1001. When the processor 1002 executes an application stored in the memory 1003, an image data signal and/or an input control signal may be transmitted to the display module 1001, and the display module 1001 may process a signal received and output image information through a display screen.

The power module 1004 may include a power supply module such as a power adapter or a battery device, and a power conversion module that converts the power supplied by the power supply module to generate power necessary for the operation of the electronic apparatus 1000.

At least one of the components of the electronic apparatus 1000 described above may be included in the display apparatus according to the embodiments described above. In addition, a part among the individual modules functionally included in one module may be included in the display apparatus, and another part may be provided separately from the display apparatus. For example, the display apparatus may include the display module 1001, and the processor 1002, the memory 1003, and the power module 1004 may be provided in the form of other apparatuses within the electronic apparatus 1000 except for the display apparatus.

In an embodiment, the display module 1001 included in the display apparatus may drive based on the image data signal and the input control signal received from the processor 1002.

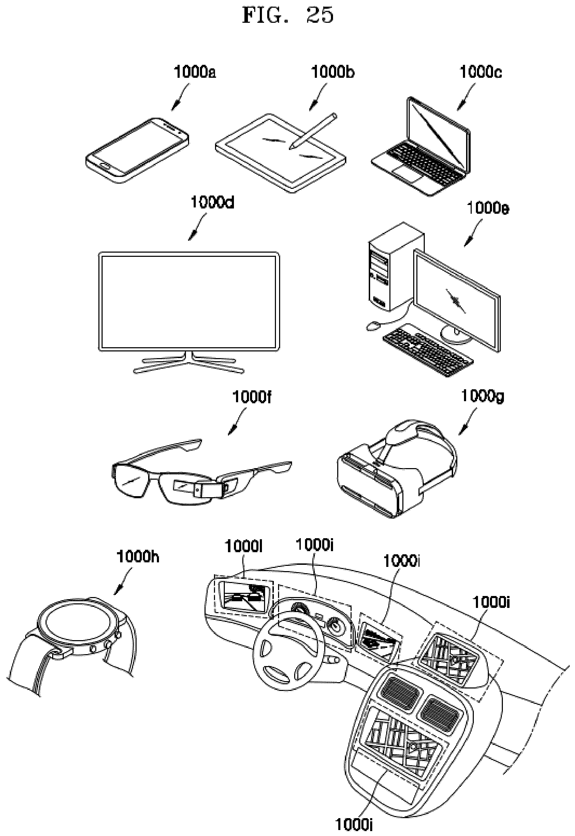

Fig. 25 is schematic diagrams of electronic apparatuses according to various embodiments.

Referring to FIG. 25, various electronic apparatuses to which display apparatuses according to embodiments are applied may include not only image display electronic apparatuses such as a smart phone 1000a, a tablet PC 1000b, a laptop 1000c, a TV 1000d, and a desk monitor 1000e, but also a wearable electronic device including display modules such as smart glasses 1000f, a head mounted display 1000g, and a smart watch 1000h, and a vehicle electronic device 1000i including a dashboard, a center fascia, and display modules such as a CID (Center Information Display) and a room mirror display disposed in the dashboard.

According to an embodiment, because the brightness difference depending on the voltage of the display apparatus may be reduced by reducing the coupling effect of the parasitic capacitor formed between the repair line used in the repair process and the pixel electrode, the display quality of the display apparatus may be improved. However, the scope of the disclosure is not limited by this effect.

It should be understood that embodiments described herein should be considered in a descriptive sense only and not for purposes of limitation. Descriptions of features or aspects in each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (1) comprising:
a substrate (100) including an active area (AA) and a dummy area (DA) disposed outside the active area;
a pixel circuit (PC) disposed in the active area and a light-emitting element electrically connected to the pixel circuit and including a pixel electrode;
a dummy circuit (DC) disposed in the dummy area;
a repair line (RL) extending in a first direction on the substrate (100), the repair line being electrically connected to the dummy circuit and connectable to the light-emitting element;
a pixel connection electrode (1620a, 1620b, 1620c) disposed to overlap the repair line and electrically connected to the pixel electrode; and
a voltage transfer line (1610, 1610') that transfers a voltage to the pixel circuit, the voltage transfer line (1610, 1610') being disposed to overlap the repair line and spaced apart from the pixel connection electrode,
wherein an area of a portion of the voltage transfer line (1610, 1610') overlapping the repair line (RL) is greater than an area of a portion of the pixel connection electrode (1620a, 1620b, 1620c) overlapping the repair line (RL).

2. The display apparatus (1) of claim 1, wherein a width of the portion of the voltage transfer line (1610, 1610') overlapping the repair line in the first direction is greater than a width of the portion of the pixel connection electrode (1620a, 1620b, 1620c) overlapping the repair line (RL) in the first direction.

3. The display apparatus (1) of claim 2, wherein a width of a portion of the repair line (RL) overlapping the voltage transfer line (1610, 1610') in a second direction perpendicular to the first direction is greater than a width of a portion of the repair line (RL) overlapping the pixel connection electrode (1620a, 1620b, 1620c) in the second direction.

4. The display apparatus (1) of claim 3, wherein a width of the portion of the voltage transfer line (1610, 1610') overlapping the repair line (RL) in the second direction is greater than a width of the portion of the pixel connection electrode (1620a, 1620b, 1620c) overlapping the repair line in the second direction.

5. The display apparatus (1) of any of the preceding claims, further comprising:
a voltage line that transfers a voltage to the voltage transfer line (1610, 1610'),
wherein the voltage line is disposed on the voltage transfer line (1610, 1610').

6. The display apparatus (1) of claim 5, wherein the voltage line is configured to transfer a direct current voltage.

7. The display apparatus (1) of claim 5 or 6, wherein the voltage line is configured to transfer a driving voltage.

8. The display apparatus (1) of any of the preceding claims, further comprising:
a first transistor (T1) disposed on the substrate (100) and including a first semiconductor layer (1100) and a first gate electrode (GE1) overlapping the first semiconductor layer (1100); and
a second transistor (T2) including a second semiconductor layer (1400) disposed on the first gate electrode and a second gate electrode (GE2) overlapping the second semiconductor layer (1400),
wherein the repair line (RL) and the second gate electrode (GE2) of the second transistor (T2) are disposed on a same layer.

9. The display apparatus (1) of claim 8, wherein
the first semiconductor layer (1100) includes a silicon semiconductor material, and
the second semiconductor layer (1400) includes an oxide semiconductor material.

10. The display apparatus (1) of any of the preceding claims, wherein the pixel connection electrode (1620a, 1620b, 1620c) and the voltage transfer line (1610, 1610') are disposed on a same layer.

11. The display apparatus (1) of claim 1, wherein the pixel connection electrode (1620a, 1620b, 1620c) and the voltage transfer line (1610, 1610') are disposed on different layers from each other.

12. The display apparatus (1) of claim 1, further comprising:
a plurality of pixels disposed in the active area (AA) and each including the pixel circuit and the light-emitting element;
a first semiconductor layer (1100) disposed on the substrate (100);
a first gate layer disposed on the first semiconductor layer (1100);
a second gate layer disposed on the first gate layer;
a second semiconductor layer (1400) disposed on the second gate layer;
a third gate layer disposed on the second semiconductor layer (1400), the third gate layer including a repair line, wherein,
and
a connection electrode layer disposed on the third gate layer and including the pixel connection electrode and a voltage transfer line (1610, 1610'),
wherein the repair line is connectable to the light-emitting element of a defective pixel of the plurality of pixels.

13. The display apparatus (1) of claim 12, wherein
the connection electrode layer further includes a scan line extending in the first direction,
the scan line is spaced apart from the voltage transfer line (1610, 1610'), and
the scan line is configured to transfer a scan signal.

14. An electronic apparatus (1000) comprising a display apparatus (1) of any of the preceding claims.

15. The electronic apparatus (1000) of claim 14, further comprising:
a display module (1001);
a processor (1002); a power module (1004); and
a memory (1003),
wherein the display apparatus (1) includes one of the display module (1001), the processor (1002), the power module (1004), or the memory (1003).
